# EUROPEAN PATENT SPECIFICATION

(11) **EP 4 256 660 B1**
(45) Date of publication and mention of the grant of the patent: **31.12.2025**
(21) Application number: 21720428.8
(22) Date of filing: 19.04.2021
(51) Int. Cl.: H01S 5/026, H01S 5/0625, H01S 5/40, H04B 10/50

(54) **DUAL OUTPUT DIRECTLY MODULATED LASER DEVICE, OPTICAL NETWORK UNIT, AND PASSIVE OPTICAL NETWORK**
DIREKT MODULIERTE LASERVORRICHTUNG MIT ZWEI AUSGÄNGEN, OPTISCHE NETZWERKEINHEIT UND PASSIVES OPTISCHES NETZWERK
DISPOSITIF LASER À MODULATION DIRECTE À DOUBLE SORTIE, UNITÉ DE RÉSEAU OPTIQUE ET RÉSEAU OPTIQUE PASSIF

(43) Date of publication of application: 11.10.2023
(73) Proprietor: Huawei Technologies Co., Ltd., Shenzhen, Guangdong 518129 (CN)
(72) Inventor: CANO VALADEZ, Ivan, Nicolas, 80992 Munich (DE); YE, Zhicheng, 80992 Munich (DE); HANTSCHMANN, Constanze, 80992 Munich (DE)
(74) Representative: Grünecker Patent- und Rechtsanwälte PartG mbB
(86) International application number: PCT/EP2021/060070
(87) International publication number: WO 2022/223092

(56) References cited:
- EP-A2- 1 318 583
- US-A1- 2012 257 645
- US-A1- 2015 078 751

## Description

### TECHNICAL FIELD

The present disclosure relates generally to the field of optical communication; and more specifically, to a dual output directly modulated laser device, an optical network unit, and a passive optical network.

### BACKGROUND

Generally, a passive optical network (PON) may be defined as an optical network that uses fiber-optic telecommunications technology for delivering broadband network access to end-users. The typical PON is a point-to-multipoint optical network in which a single optical fiber is used to serve multiple end-users. The typical PON uses passive optical components (i.e., optical components which do not require power supply to operate), in order to divide the fiber-bandwidth among multiple end-users (or access points). The typical PON comprises of three major components: an optical line termination (OLT), a passive optical connector, and a set of conventional optical network units (ONUs). The OLT is a special-purpose switch located at a service provider's central office, which connects a backbone network to the set of conventional ONUs through the passive optical connector (e.g., splitter, coupler, and splicer). Each of the set of conventional ONUs may be referred to a user side equipment, which converts the fiber optic signal into an electric signal at the user side and enables reliable fiber optic ethernet services to business or residential users. Examples of the conventional PON include, but are not limited to, fiber to the home (FTTH), fiber to the curb (FTTC), fiber to the building (FTTB), fiber to the floor (FTTF), fiber to the room (FTTR), and the like.

US2015/078751 A1 relates to tunable lasers and more particularly, to a tunable laser with multiple in-line sections including sampled gratings configured for tuning within multiple different ranges of channel wavelengths for use in tunable transmitters or transceivers in a wavelength division multiplexed (WDM) passive optical network (PON). EP 1 318 583 A2 relates to a semiconductor laser device that has two stripe structures, a semiconductor laser module and an optical fiber amplifier and that is compact and easy to manufacture, and achieves high output power while reducing Stimulated Brillouin scattering in Raman amplifier and the degree of polarization of the laser beam emitted from the semiconductor laser device. US 2012/257645 A1 relates to a beat signal generating device for a Terahertz system and a Terahertz system that can be produced as cost-effective as possible.

With recent development in optical communication, next-generation passive optical networks (PONs) are aimed to provide increased data rates, such as the data rates greater than or equal to 10 Gigabits per second (Gbps), to a campus, to a factory, to a building, and even to a room. The conventional PONs which could link a 'main PON', such as a fiber to the building (FTTB), to a 'sub-PON', such as a fiber to the room (FTTR), use multiple separately packaged devices which are required to create optical links between the 'main-PON' and the 'sub-PON'. Such conventional approach is neither cost-effective nor energy-efficient, as it simply duplicates the respective component cost by adding the cost of the 'sub-PON' to the 'main PON' and results in the requirement of optical attenuators to adjust optical power level at the 'sub-PON' receiver. An independent dual-channel laser operation of a monolithic device may therefore be utilized in form of a symmetric double-sided semiconductor laser device. This type of symmetric double-sided semiconductor laser device has a central distributed feedback (DFB) section and electro-absorption-modulation sections at both laser facets, and is used to produce increased data rates (e.g., 112Gbps and 120 Gbaud) with partial energy efficiency. Although the symmetric double-sided electro-absorption modulated laser (EML) device is a monolithic device which share a common gain and absorption medium, however, the conventional single-sided EML device requires an epitaxial regrowth step to combine two different materials for the gain and the absorption region. This generally reduces fabrication yield, which makes the conventional EML device a much more costly solution, rendering them economically unfeasible for use in optical access ONUs, where the system cost is a primary concern. In addition, such conventional EML device offers limited flexibility to adjust the optical power level at each facet, while the general power level after the external modulation process also tends to be low. Thus, there exists a technical problem of low energy efficiency and high implementation cost of the conventional laser device and the conventional PONs.

Therefore, in light of the foregoing discussion, there exists a need to overcome the aforementioned drawbacks associated with the conventional laser device and hence, the conventional PONs.

### SUMMARY

The present disclosure provides a dual output directly modulated laser device, an optical network unit, and a passive optical network. The present disclosure provides a solution to the existing problem of low energy efficiency and high implementation cost associated with the conventional PONs, where the problem is compounded by the fact that in existing PONs, multiple separately packaged devices are used to create an optical link between a main-PON and a sub-PON, which increases the overall implementation cost and power consumption of the conventional PONs. An aim of the present disclosure is to provide a solution that overcomes at least partially the problems encountered in prior art, and provides an improved laser device that can simultaneously be used for a main-PON upstream and a sub-PON downstream transmission, thus, providing an energy efficient and cost-effective PON as compared to the conventional PONs.

One or more objects of the present disclosure is achieved by the solutions provided in the enclosed independent claims. Advantageous implementations of the present disclosure are further defined in the dependent claims.

In one aspect, the present disclosure provides a dual output directly modulated laser device for generating two distinct optical output signals. The dual output directly modulated laser device comprises two outer gain sections, each directly modulated by injection of a respective modulation current and a central section comprising a distributed reflector providing optical feedback to both outer gain sections to prevent crosstalk between the two outer gain sections. The two outer gain sections form two laser cavities each configured to emit a directly modulated signal as an optical output signal in a direction away from the central section.

The dual output directly modulated laser device of the present disclosure generates two distinct optical output signals, one from each laser cavity. By virtue of providing the two optical output signals, an overall implementation cost of an optical network architecture (e.g., a passive optical network, PON) can be reduced. The dual output directly modulated laser device provides enhanced functionality in a way that the two distinct optical output signals have both main-PON upstream and sub-PON downstream capabilities. Thus, the dual output directly modulated laser device provides the functionality of two separate directly modulated laser devices in a single laser device which further results into more energy efficiency, reduced power consumption and low component cost. Moreover, unlike the conventional electro-absorption modulated sections (EMLs), no additional epitaxial overgrowth step is required in the dual output directly modulated laser device, resulting into a simplified fabrication process and a low manufacturing cost as well.

In an implementation form, a length of the central section is selected such that transmission between the outer gain sections is less than a predefined level.

A suitable selection of the length of the central section ensures a crosstalk-free dual-output direct modulation in the laser device.

In a further implementation form, a length of a first outer gain section is longer than a length of a second outer gain section, such that a power output of a corresponding first laser cavity is greater than a power output of a second laser cavity.

The length of the first outer gain section is kept longer than the length of the second outer gain section to produce asymmetric outer gain sections. By virtue of asymmetric outer gain sections, the respective output optical signals from the laser cavities formed by the two outer gain sections, can be operated at different optical power levels as required by an optical network architecture to match the respective link power budget. Thus, asymmetric outer gain sections can reduce power consumption and simplify the optical network architecture by eliminating the requirement for optical attenuators.

In a further implementation form, a data rate of a first modulation current is different to a data rate of a second modulation current.

Beneficially, the two distinct optical output signals with different data rates generated from the dual output directly modulated laser device can be used for a main-PON upstream and a sub-PON downstream, simultaneously, and results into further energy saving.

In a further implementation form, the central section comprises an active region material biased such that an optical gain of the central section is substantially the same or less than an aggregated optical loss associated with the central section.

By virtue of biasing the active region material of the central section, the dual output directly modulated laser device becomes optically transparent and the generation of stimulated photons is prevented in the central reflector section. Hence, crosstalk between uncorrelated photons from the central reflector section and the two optical modulation signals from the outer gain sections of the dual output directly modulated laser device is prevented, while excess absorption loss in the central reflector section is reduced.

In a further implementation form, the two outer gain sections share a common active region material layer with the central section.

Beneficially, no additional epitaxial overgrowth step is required which simplifies the fabrication process of the laser device and a low manufacturing cost as well.

In a further implementation form, an active region material layer of the laser device is formed of two halves, each half configured to emit a different wavelength band.

The active region material layer of the dual output directly modulated laser device is formed of two halves to allow emission in two completely different wavelength bands (e.g., 1270 nanometre and 1490 nanometre for gigabit passive optical network (GPON) or extended gigabit passive optical network (XGPON)).

In a further implementation form, the central section comprises a waveguide formed from a passive material.

Beneficially, the requirements on the biasing level accuracy of the central section can be relaxed by alleviating the requirement to stay at or below the transparency level.

In a further implementation form, the reflector is a high-refractive index distributed Bragg reflector.

The central section comprises of a high refractive index distributed Bragg reflector which serves as a mirror and hence, provides a sufficient optical feedback to the two outer gain sections.

In a further implementation form, the laser device is divided into three independent sections by etching isolation trenches between adjacent electrical contacts for each of the section.

Beneficially, the two outer gain sections and the central section can be formed with same epitaxial material and no additional epitaxial overgrowth step is required.

In a further implementation form, each of the cavities is configured as a Fabry-Perot-type cavity.

The two outer gain sections may be configured as a Fabry-Perot-type cavity and used in a case where improved mode selectivity is not required.

In a further implementation form, each of the cavities comprises a grating to select a predefined wavelength for the cavity.

By virtue of the grating, a predefined wavelength for each of the outer gain sections can be selected to reduce crosstalk.

In a further implementation form, a different wavelength is selected for each cavity.

By virtue of the grating, emission of optical output signal at different wavelengths is possible to reduce crosstalk.

In another aspect, the present disclosure provides an optical network unit (ONU). The ONU is configured to receive data from a downstream main passive optical network (PON). The ONU comprises the laser device. A first laser cavity of the laser device is configured to transmit a first directly modulated signal to the upstream main PON and a second laser cavity of the laser device is configured to transmit a second directly modulated signal to a downstream sub-PON.

The optical network unit (ONU) of the present disclosure provides an energy efficient way to connect the upstream main-PON and the downstream sub-PON. The ONU comprises the dual output directly modulated laser device, which provides two distinct optical output signals in order to connect the upstream main-PON and the downstream sub-PON simultaneously, resulting into low power consumption and more energy efficiency.

In a yet another aspect, the present disclosure provides a passive optical network (PON). The PON comprises a main PON configured to transmit and receive data to and from a plurality of ONUs. The PON further comprises a plurality of sub-PONs corresponding receive and transmit data from and to the plurality of ONUs.

The passive optical network (PON) of the present disclosure provides an energy efficient way to deliver broadband network access to end-users at a high-speed data rate. The PON provides an improved bandwidth, high flexibility, high reliability, high adaptability, easy management, and low cost per end-user. By virtue of the PON, large number of end-users connected to the plurality of sub-PONs can access high speed data at very low cost.

It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIG. 1 is a schematic view of a dual output directly modulated laser device, in accordance with an embodiment of the present disclosure;
FIG. 2 is a schematic view of a dual output directly modulated laser device, in accordance with another embodiment of the present disclosure;
FIG. 3 is a schematic view of a dual output directly modulated laser device, in accordance with yet another embodiment of the present disclosure;
FIG. 4 is a schematic view of a dual output directly modulated laser device, in accordance with yet another embodiment of the present disclosure;
FIG. 5 is a schematic view of a dual output directly modulated laser device, in accordance with yet another embodiment of the present disclosure;
FIG. 6 is a schematic view of a dual output directly modulated laser device, in accordance with yet another embodiment of the present disclosure;
FIG. 7A is a graphical representation that depicts a temporal evolution of an optical output power of a first directly modulated optical output signal of a laser device, in accordance with an embodiment of the present disclosure;
FIG. 7B is a graphical representation that depicts a temporal evolution of an optical output power of a second directly modulated optical output signal a laser device, in accordance with an embodiment of the present disclosure;
FIG. 8A is a graphical representation that depicts an eye diagram of a first directly modulated optical output signal of a laser device, in accordance with an embodiment of the present disclosure;
FIG. 8B is a graphical representation that depicts an eye diagram of a second directly modulated optical output signal of a laser device, in accordance with an embodiment of the present disclosure;
FIG. 9 is a graphical representation that depicts distribution of an optical gain in each section of a laser device, in accordance with an embodiment of the present disclosure;
FIG. 10A is a graphical representation that depicts distribution of a photon density in each section of a laser device on a linear scale, in accordance with an embodiment of the present disclosure;
FIG. 10B is a graphical representation that depicts distribution of a photon density in each section of a laser device on a logarithmic scale, in accordance with an embodiment of the present disclosure;
FIG. 11A is a graphical representation that depicts a temporal evolution of an optical output power of a first directly modulated optical output signal of a laser device, in accordance with another embodiment of the present disclosure;
FIG. 11B is a graphical representation that depicts a temporal evolution of an optical output power of a second directly modulated optical output signal a laser device, in accordance with another embodiment of the present disclosure;
FIG. 12A is a graphical representation that depicts an eye diagram of a first directly modulated optical output signal of a laser device, in accordance with another embodiment of the present disclosure;
FIG. 12B is a graphical representation that depicts an eye diagram of a second directly modulated optical output signal of a laser device, in accordance with another embodiment of the present disclosure;
FIG. 13 is a graphical representation that depicts distribution of an optical gain in each section of a laser device, in accordance with another embodiment of the present disclosure;
FIG. 14A is a graphical representation that depicts distribution of a photon density in each section of a laser device on a linear scale, in accordance with another embodiment of the present disclosure;
FIG. 14B is a graphical representation that depicts distribution of a photon density in each section of a laser device on a logarithmic scale, in accordance with another embodiment of the present disclosure;
FIG. 15A is a graphical representation that depicts a temporal evolution of an optical output power of a first directly modulated optical output signal of a laser device, in accordance with yet another embodiment of the present disclosure;
FIG. 15B is a graphical representation that depicts a temporal evolution of an optical output power of a second directly modulated optical output signal a laser device, in accordance with yet another embodiment of the present disclosure;
FIG. 16A is a graphical representation that depicts an eye diagram of a first directly modulated optical output signal of a laser device, in accordance with yet another embodiment of the present disclosure;
FIG. 16B is a graphical representation that depicts an eye diagram of a second directly modulated optical output signal of a laser device, in accordance with yet another embodiment of the present disclosure;
FIG. 17 is a graphical representation that depicts distribution of an optical gain in each section of a laser device, in accordance with yet another embodiment of the present disclosure;
FIG. 18A is a graphical representation that depicts distribution of a photon density in each section of a laser device on a linear scale, in accordance with yet another embodiment of the present disclosure;
FIG. 18B is a graphical representation that depicts distribution of a photon density in each section of a laser device on a logarithmic scale, in accordance with yet another embodiment of the present disclosure; and
FIG. 19 is an implementation scenario of a passive optical network, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

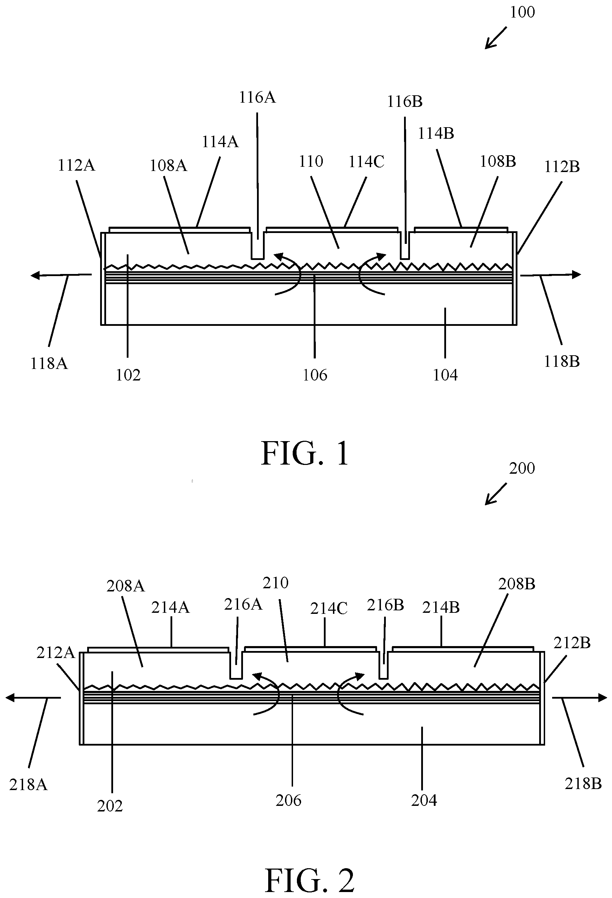

FIG. 1 is a schematic view of a dual output directly modulated laser device, in accordance with an embodiment of the present disclosure. With reference to FIG. 1, there is shown a dual output directly modulated laser device (hereinafter simply referred to as a laser device **100)** that includes an upper p-doped layer **102,** a lower n-doped layer **104,** and an active region material layer **106.** The laser device **100** further includes two outer gain sections, such as a first outer gain section **108A** and a second outer gain section **108B,** and a central section **110.** The laser device **100** further includes two laser cavities, such as a first laser cavity formed between the central section **110** and a laser facet **112A** and a second laser cavity formed between the central section **110** and a laser facet **112B.** There is further shown three electrical contacts, such as a first electrical contact **114A,** a second electrical contact **114B,** and a third electrical contact **114C,** and two isolation trenches, such as a first isolation trench **116A** and a second isolation trench **116B.** The laser device **100** generates two directly modulated optical output signals, such as a first directly modulated optical output signal **118A** and a second directly modulated optical output signal **118B.**

The present disclosure provides a dual output laser directly modulated laser device (i.e., the laser device **100)** for generating two distinct optical output signals, comprising:
two outer gain sections, each directly modulated by injection of a respective modulation current; and
a central section **110** comprising a distributed reflector providing optical feedback to both outer gain sections while preventing the generation of stimulated photons;
wherein the two outer gain sections form two laser cavities each configured to emit a directly modulated signal as an optical output signal in a direction away from the central section **110.**

The dual output laser directly modulated laser device (i.e., the laser device **100)** may also be referred to as a semiconductor laser or a diode laser. The laser device **100** may be used for, but is not limited to optical telecommunications, optical data storage, metrology, spectroscopy, material processing, pumping of other lasers, and medical treatments. Examples of the laser device **100** include, but are not limited to a double heterostructure lasers. quantum well lasers, quantum cascade lasers, inter-band cascade lasers, separate confinement heterostructure lasers, distributed Bragg reflector lasers, distributed feedback lasers, vertical-cavity surface-emitting laser, vertical-external-cavity surface-emitting-laser, external-cavity diode lasers, and the like.

The dual output laser directly modulated laser device (i.e., the laser device **100)** comprises two outer gain sections, each directly modulated by injection of a respective modulation current. The two outer gain sections, such as the first outer gain section **108A** and the second outer gain section **108B,** may also be referred to as directly modulated gain sections (or distributed feedback (DFB) type gain sections). Each of the first outer gain section **108A** and the second outer gain section **108B** has a grating coupling factor, k₁ and k₂, respectively. Each of the first outer gain section **108A** and the second outer gain section **108B** is biased far above a threshold value of the laser device **100** in order to enable a direct and independent modulation through injection of the respective modulation current. Additionally, an optical output of each of the first outer gain section **108A** and the second outer gain section **108B,** can be directly controlled by injection of the respective modulation current. In other words, the directly modulated optical output of the laser device **100** (i.e., the first directly modulated optical output signal **118A** and the second directly modulated optical output signal **118B)** follows the respective modulation current applied to each of the first outer gain section **108A** and the second outer gain section **108B.**

The laser device **100** further comprises the central section **110** comprising a distributed reflector providing optical feedback to both outer gain sections while preventing the generation of stimulated photons. The central section **110** comprises the distributed reflector, for example, a distributed Bragg reflector. The distributed reflector is a high refractive index reflector which serves as a mirror and hence, provides an optical feedback to each of the first outer gain section **108A** and the second outer gain section **108B.**

The two outer gain sections form two laser cavities each configured to emit a directly modulated signal as an optical output signal in a direction away from the central section **110.** The two outer gain sections, such as the first outer gain section **108A** and the second outer gain section **108B,** build two independent laser cavities, such as the first laser cavity between the central section **110** and the laser facet **112A** and the second laser cavity between the central section **110** and the laser facet **112B,** where light oscillates between the respective as-cleaved or anti-reflection coated output facet and the central distributed Bragg reflector. The two directly modulated optical output signals, such as the first directly modulated optical output signal **118A** and the second directly modulated optical output signal **118B,** are emitted through the two laser facets, such as the first laser facet **112A** and the second laser facet **112B,** respectively. Each of the first directly modulated optical output signal **118A** and the second directly modulated optical output signal **118B,** is emitted in opposite directions that is in a direction away from the central section **110.**

In accordance with an embodiment, the reflector is a high-refractive index distributed Bragg reflector. The central section **110** of the laser device **100** comprises the high refractive index difference distributed Bragg reflector, which is a structure formed from a periodic variation of the refractive index of some characteristic, such as a periodic variation of the dimensions, e.g. the height and/or width, of a waveguide or multiple layers of alternating materials with varying refractive index, resulting in periodic variation in the effective refractive index in the waveguide. The distributed Bragg reflector serves as a mirror in the central section **110** and hence, provides an optical feedback to each of the first outer gain section **108A** and the second outer gain section **108B.**

In accordance with an embodiment, the laser device **100** is divided into three independent sections by etching isolation trenches between adjacent electrical contacts for each of the section. The laser device **100** is divided into three independent sections, that is the first outer gain section **108A,** the central section **110,** and the second outer gain section **108B,** by use of etching isolation trenches, such as the first isolation trench **116A** and the second isolation trench **116B.** Each of the first isolation trench **116A** and the second isolation trench **116B** is formed between adjacent electrical contacts, such as the first electrical contact **114A,** the second electrical contact **114B,** and the third electrical contact **114C.** The first isolation trench **116A** is formed between the first outer gain section **108A** and the central section **110** to achieve an electrical isolation between the first outer gain section **108A** and the central section **110.** The second isolation trench **116B** is formed between the central section **110** and the second outer gain section **108B** to achieve an electrical isolation between the central section **110** and the second outer gain section **108B.** The first electrical contact **114A** is formed over the first outer gain section **108A** and is used for injection of the respective modulation current into the first outer gain section **108A.** Similarly, the second electrical contact **114B** is formed over the second outer gain section **108B** and is used for injection of the respective modulation current into the second outer gain section **108B.** The third electrical contact **114C** is formed over the central section **110** and is used for biasing the central section **110.** Each of the first isolation trench **116A** and the second isolation trench **116B** may also be referred to as an isolation groove.

In accordance with an embodiment, the two outer gain sections share a common active region material layer with the central section **110.** The laser device **100** comprises the upper p-doped layer **102,** the lower n-doped layer **104,** and the active region material layer **106.** The upper p-doped layer **102** is formed by doping of p-type impurities, whereas the lower n-doped layer **104** is formed by doping of n-type impurities. The active region material layer **106** is sandwiched (or common) between the upper p-doped layer **102** and the lower n-doped layer **104.** The active region material layer **106** may correspond to a multi-quantum well active region. The two outer gain sections, such as the first outer gain section **108A** and the second outer gain section **108B,** and the central section **110** of the laser device **100** are formed on the same epitaxial material (i.e., the active region material layer **106**). Therefore, in contradiction to the conventional EMLs, no additional epitaxial overgrowth step is required in the laser device **100.**

In accordance with an embodiment, a length of the central section **110** is selected such that transmission between the outer gain sections is less than a predefined level. The central section **110** is located in between the first outer gain section **108A** and the second outer gain section **108B.** The length of the central section **110** is selected such that transmission between the first outer gain section **108A** and the second outer gain section **108B,** is less than the predefined level, which may be obtained with reduced photon density between them. Therefore, the length of the central section **110** has to be of sufficient dimensions in order to provide a sufficient optical feedback to each of the first outer gain section **108A** and the second outer gain section **108B.** Moreover, a suitable selection of the length of the central section **110** ensures a crosstalk-free dual-output direct modulation in the laser device **100.**

In accordance with an embodiment, a length of the first outer gain section **108A** is longer than a length of the second outer gain section **108B,** such that a power output of the corresponding first laser cavity emitted at facet **112A** is greater than a power output of the second laser cavity emitted at facet **112B.** The length of the first outer gain section **108A** is kept longer than the length of the second outer gain section **108B** to produce asymmetric outer gain sections. By virtue of asymmetric outer gain sections, each of the first directly modulated optical output signal **118A** and the second directly modulated optical output signal **118B** emitted from the two laser cavities, such as at the first laser facet **112A** and at the second laser facet **112B,** respectively, can be operated at different optical power levels in order to match a respective link power budget. The asymmetric outer gain sections, such as the first outer gain section **108A** (i.e., the longer one) and the second outer gain section **108B** (i.e., the shorter one), may further reduce power consumption and simplify a passive optical network architecture by eliminating the need for optical attenuators. Optionally, the grating coupling factors (k₁, k₂) of the two outer gain sections, such as the first outer gain section **108A** and the second outer gain section **108B,** can be different or same, although a lower value of grating coupling factor (k) is preferred for longer and higher power gain sections in order to avoid too high optical power propagating into the central section **110.**

In accordance with an embodiment, a data rate of a first modulation current is different to a data rate of a second modulation current. The first modulation current is injected into the first outer gain section **108A** through the first electrical contact **114A,** while the second modulation current is injected into the second outer gain section **108B** through the second electrical contact **114B.** The data rate of the first modulation current is kept different from the data rate of the second modulation current. Alternatively stated, the two distinct directly modulated optical output signals, such as the first directly modulated optical output signal **118A** and the second directly modulated optical output signal **118B,** with different data rates are generated from the respective outer gain sections, such as the first outer gain section 108A and the second outer gain section **108B,** because, the directly modulated optical output signals **(118A, 118B)** are directly controlled by their respective modulation currents.

In accordance with an embodiment, the central section **110** comprises the active region material layer **106** biased such that an optical gain of the central section **110** is substantially the same or less than an aggregated optical loss associated with the central section **110.** The active region material layer **106** of the central section **110** is biased through the third electrical contact **114C.** The biasing of the active region material layer **106** of the central section **110** is done either at or below a transparency level. The transparency level may be defined as an operation point at which the optical gain (g) of the central section **110** is substantially the same or less than the aggregated optical loss (α) associated with the central section **110.** Thus, the laser device **100** becomes optically transparent at the transparency level. This is done in order to provide optical feedback to each of the first outer gain section **108A** and the second outer gain section **108B** while preventing the generation of stimulated photons (g>0) or the induction of the substantial optical loss (g<<0) in the central section **110.** In this way, the electro-absorption modulation sections are not required in the laser device **100** as they are replaced by directly modulated sections (i.e., the first outer gain section **108A** and the second outer gain section **108B).** Thus, the laser device **100** manifests a lower cost in comparison to a conventional laser device.

Thus, the laser device **100** provides two distinct optical output signals that is the first directly modulated optical output signal **118A** and the second directly modulated optical output signal **118B** emitted from the first laser cavity **112A** and the second laser cavity **112B,** respectively. Thus, the laser device **100** combines the functionality of two separate DMLs in a single device. Additionally, the growth procedure of the laser device **100** incurs low cost in comparison to a conventional distributed feedback directly modulated laser (DFB DML) device. In contradiction to the conventional electro-absorption modulated sections (EMLs) no additional epitaxial overgrowth step is required which simplifies the fabrication of the laser device **100.** Moreover, each of the first directly modulated optical output signal **118A** and the second directly modulated optical output signal **118B** can be operated either at the same or different data rates as well as the same or different optical power levels depending on an optical network architecture. One of the first directly modulated optical output signal **118A** and the second directly modulated optical output signal **118B** may be used as upstream transmitted signal to a 'main PON' (e.g., a fiber to the building, FTTB, network) and the other may be used as time-division-multiplexed downstream signals towards a 'sub-PON' (e.g., a fiber to the room, FTTR) end users. The different optical power levels associated with each of the first directly modulated optical output signal **118A** and the second directly modulated optical output signal **118B** is enabled by virtue of designing the first outer gain section **108A** (i.e., the longer one) and the second outer gain section **108B** (i.e., the shorter one) in an asymmetric way, so that the optical output level at each laser facet (i.e., **112A, 112B)** can be adjusted in order to match a respective link power budget. This may further result into a reduced power consumption and high energy efficiency of the laser device **100** and a simplified network architecture which eliminates the optical attenuators. In a case, if a thermoelectric cooler (TEC) is required, this may also be shared by the two outer gain sections (i.e., the first outer gain section **108A** and the second outer gain section **108B).**

FIG. 2 is a schematic view of a dual output directly modulated laser device, in accordance with another embodiment of the present disclosure. FIG. 2 is described in conjunction with elements from FIG. 1. With reference to FIG. 2, there is shown a dual output directly modulated laser device (hereinafter simply referred to as a laser device **200)** that includes an upper p-doped layer **202,** a lower n-doped layer **204,** and an active region material layer **206.** The laser device **200** further includes two outer gain sections, such as a first outer gain section **208A** and a second outer gain section **208B,** and a central section **210.** The laser device **200** further includes two laser cavities, such as a first laser cavity formed between the central section **210** and the laser facet **212A** and a second laser cavity formed between the central section **210** and the laser facet **212B.** There is further shown three electrical contacts, such as a first electrical contact **214A,** a second electrical contact **214B,** and a third electrical contact **214C,** and two isolation trenches, such as a first isolation trench **216A** and a second isolation trench **216B.** The laser device **200** generates two directly modulated optical output signals, such as a first directly modulated optical output signal **218A** and a second directly modulated optical output signal **218B.**

The laser device **200** corresponds to the laser device **100** (of FIG. 1) except a difference. The difference is that, in the laser device **200,** the two outer gain sections, such as the first outer gain section **208A** and the second outer gain section **208B,** are designed in a symmetric way. This means that the length of the first outer gain section **208A** and the second outer gain section **208B** is kept same. The laser device **200** is a first alternative implementation of the laser device **100.** By virtue of having equal length of the first outer gain section **208A** and second outer gain section **208B,** the laser device **200** allows same or similar power launch level at each output facet **212A** as well as **212B.**

Working and connections of the upper p-doped layer **202,** the lower n-doped layer **204,** the active region material layer 206, the central section **210,** the first laser cavity between the central section **210** and the laser facet **212A,** the second laser cavity between the central section **210** and the laser facet **212B,** the first electrical contact **214A,** the second electrical contact **214B,** the third electrical contact **214C,** the first isolation trench **216A,** the second isolation trench **216B,** the first directly modulated optical output signal **218A,** and the second directly modulated optical output signal **218B,** of the laser device **200** is same that has been described in detail, for example, in FIG. 1 and hence, omitted here for the sake of brevity.

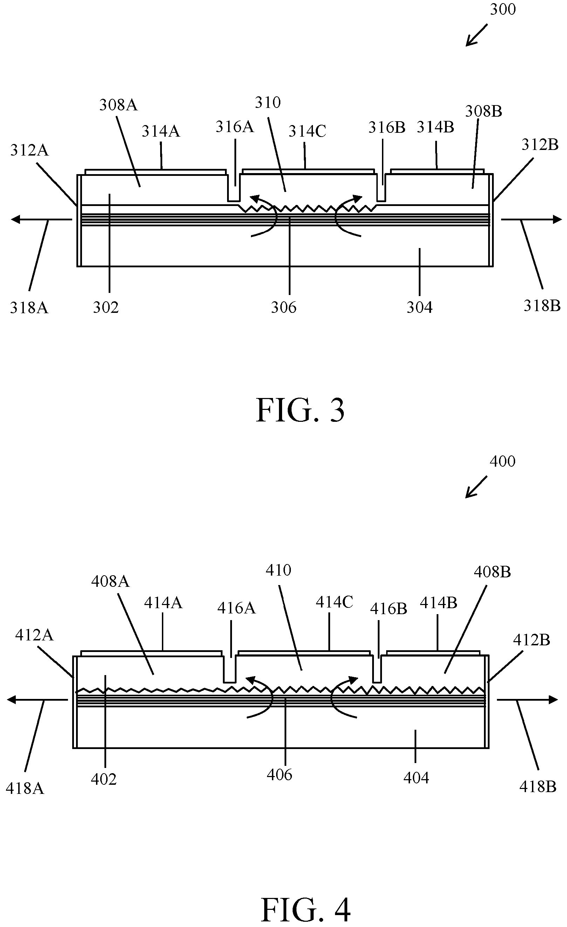

FIG. 3 is a schematic view of a dual output directly modulated laser device, in accordance with yet another embodiment of the present disclosure. FIG. 3 is described in conjunction with elements from FIG. 1 and FIG. 2. With reference to FIG. 3, there is shown a dual output directly modulated laser device (hereinafter simply referred to as a laser device **300)** that includes an upper p-doped layer **302,** a lower n-doped layer **304,** and an active region material layer **306.** The laser device **300** further includes two outer gain sections, such as a first outer gain section **308A** and a second outer gain section **308B,** and a central section **310.** The laser device **300** further includes two laser cavities, such as a first laser cavity formed between the central section **310** and the laser facet **312A** and a second laser cavity formed between the central section **310** and the laser facet **312B.** There is further shown three electrical contacts, such as a first electrical contact **314A,** a second electrical contact **314B,** and a third electrical contact **314C,** and two isolation trenches, such as a first isolation trench **316A** and a second isolation trench **316B.** The laser device **300** generates two directly modulated optical output signals, such as a first directly modulated optical output signal **318A** and a second directly modulated optical output signal **318B.**

The laser device **300** corresponds to the laser device **100** (of FIG. 1) except a difference. The difference is that, in the laser device **300,** the two outer gain sections, such as the first outer gain section **308A** and the second outer gain section **308B** are designed as Fabry-Perot-type gain sections apart from the distributed feedback (DFB) type gain sections as designed in the laser device **100** and the laser device **200** (of FIG. 2).

In accordance with an embodiment, each of the cavities is configured as a Fabry-Perot-type cavity. In the laser device **300,** each of the first outer gain section **308A** and the second outer gain section **308B** are designed as Fabry-Perot-type gain sections without etched grating structure in a case where improved mode selectivity is not required. In case of the Fabry-Perot-type gain sections, each of the first outer gain section **308A** and the second outer gain section **308B** can be formed by two closely spaced, partially reflecting mirrors which form a resonant optical cavity with maximum optical transmission at wavelengths that are multiples of the mirror spacing, at small incident light angles. In case of the laser device 300, two such Fabry-Perot-type cavities are formed between the central section 310 and the laser facet 312A and between the central section 310 and the laser facet 312B, respectively. Beneficially, the laser device **300** shows a multimode broad longitudinal lasing spectrum because of its Fabry-Perot-type gain sections (i.e., the first outer gain section **308A** and the second outer gain section **308B)** and has no mode-selective feedback mechanism. The laser device **300** may correspond to a second alternative implementation of the laser device **100** (of FIG. 1).

Working and connections of the upper p-doped layer **302,** the lower n-doped layer **304,** the active region material layer **306,** the central section **310,** the first laser cavity **312A,** the second laser cavity **312B,the** first electrical contact **314A,** the second electrical contact **314B,** the third electrical contact **314C,** the first isolation trench **316A,** the second isolation trench **316B,** the first directly modulated optical output signal **318A,** and the second directly modulated optical output signal **318B,** of the laser device **300** is same that has been described in detail, for example, in FIG. 1 and hence omitted here for the sake of brevity.

FIG. 4 is a schematic view of a dual output directly modulated laser device, in accordance with yet another embodiment of the present disclosure. FIG. **4** is described in conjunction with elements from FIG. 1, FIG. 2, and FIG. 3. With reference to FIG. 4, there is shown a dual output directly modulated laser device (hereinafter simply referred to as a laser device **400)** that includes an upper p-doped layer **402,** a lower n-doped layer **404,** and an active region material layer **406.** The laser device **400** further includes two outer gain sections, such as a first outer gain section **408A** and a second outer gain section **408B,** and a central section **410.** The laser device **400** further includes two laser cavities, such as a first laser cavity formed between the central section **410** and the laser facet **412A** and a second laser cavity formed between the central section **410** and the laser facet **412B.** There is further shown three electrical contacts, such as a first electrical contact **414A,** a second electrical contact **414B,** and a third electrical contact **414C,** and two isolation trenches, such as a first isolation trench **416A** and a second isolation trench **416B.** The laser device **400** generates two directly modulated optical output signals, such as a first directly modulated optical output signal **418A** and a second directly modulated optical output signal **418B.**

Working and connections of the upper p-doped layer **402,** the lower n-doped layer **404,** the active region material layer **406,** the first outer gain section **408A,** the second outer gain section **408B,** the central section **410,** the first laser cavity formed between the central section **410** and the laser facet **412A,** the second laser cavity formed between the central section **410** and the laser facet **412B,** the first electrical contact **414A,** the second electrical contact **414B,** the third electrical contact **414C,** the first isolation trench **416A,** the second isolation trench **416B,** the first directly modulated optical output signal **418A,** and the second directly modulated optical output signal **418B,** of the laser device **400** are the same as those that have been described in detail, for example, in FIG. 1 and hence, they are omitted here for the sake of brevity.

The laser device **400** corresponds to the laser device **100** (of FIG. 1) except a difference. The difference is that, in the laser device **400,** each of the first outer gain section **408A** and the second outer gain section **408B** has a different grating pitch.

In accordance with an embodiment, each of the cavities comprises a grating to select a predefined wavelength for the cavity. Alternatively stated, the first outer gain section **408A** and the second outer gain section **408B** comprises the grating pitch, *Λ*₁ and *Λ*₂, respectively. The grating pitches *Λ*₁ and *Λ*₂ of each of the first outer gain section **408A** and the second outer gain section **408B,** are detuned against each other in order to enable lasing at slightly different emission wavelengths and thus, to reduce crosstalk.

In accordance with an embodiment, a different wavelength is selected for each cavity. Each of the first outer gain section **408A** and the second outer gain section **408B** with the grating pitches, *Λ*₁ and *Λ*₂, respectively, is configured to emit the different wavelength in order to reduce crosstalk.

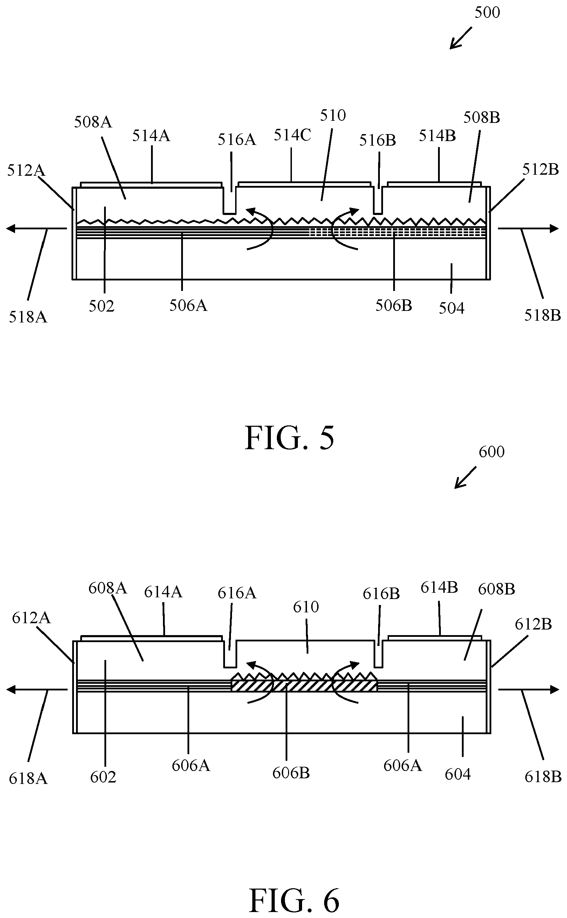

FIG. 5 is a schematic view of a dual output directly modulated laser device, in accordance with yet another embodiment of the present disclosure. FIG. 5 is described in conjunction with elements from FIG. 1, FIG. 2, FIG. 3, and FIG. 4. With reference to FIG. 5, there is shown a dual output directly modulated laser device (hereinafter simply referred to as a laser device **500)** that includes an upper p-doped layer **502,** a lower n-doped layer **504**, and an active region material layer formed of two halves, such as a first half active region material layer **506A** and a second half active region material layer **506B.** The laser device **500** further includes two outer gain sections, such as a first outer gain section **508A** and a second outer gain section **508B,** and a central section **510.** The laser device **500** further includes two laser cavities, such as a first laser cavity formed between the central section **510** and the first laser facet **512A** and a second laser cavity formed between the central section **510** and the second laser facet **512B.** There is further shown three electrical contacts, such as a first electrical contact **514A,** a second electrical contact **514B,** and a third electrical contact **514C,** and two isolation trenches, such as a first isolation trench **516A** and a second isolation trench **516B.** The laser device **500** generates two directly modulated optical output signals, such as a first directly modulated optical output signal **518A** and a second directly modulated optical output signal **518B.**

Working and connections of the upper p-doped layer **502,** the lower n-doped layer **504,** the first outer gain section **508A,** the second outer gain section **508B,** the central section **510,** the first laser cavity formed between the central section **510** and the first laser facet **512A,** the second laser cavity formed between the central section **510** and the second laser facet **512B,** the first electrical contact **514A,** the second electrical contact **514B,** the third electrical contact **514C,** the first isolation trench **516A,** the second isolation trench **516B,** the first directly modulated optical output signal **518A,** and the second directly modulated optical output signal **518B,** of the laser device **500** is same that has been described in detail, for example, in FIG. 1 and hence, omitted here for the sake of brevity.

In accordance with an embodiment, an active region material layer of the laser device **500** is formed of two halves, each half configured to emit a different wavelength band. The laser device **500** corresponds to a butt-joint laser structure which comprises two different active region material layers. Therefore, the active region material layer of the laser device **500** is formed of two halves, such as a first half active region material layer **506A** and a second half active region material layer **506B.** The first half active region material layer **506A** and the second half active region material layer **506B** may be configured to allow emission in two completely different wavelength bands (e.g., 1270 nanometre and 1490 nanometre for gigabit passive optical network (GPON) or extended gigabit passive optical network (XGPON)).

Moreover, the grating pitches (*Λ*₁ and *Λ*₂) of the first outer gain section **508A** and the second outer gain section **508B** are adjusted so that their Bragg wavelengths are in agreement with the targeted emission wavelengths. The length of each grating section (i.e., the first outer gain section **508A** and the second outer gain section **508B)** with grating pitches *Λ*₁ and *Λ*₂ within the central section **510** are adjusted to yield a sufficient feedback to the first outer gain section **508A** and the second outer gain section **508B,** as the adjacent grating section belonging to the opposing cavity is designed for a very different emission band and is thus unsuitable for providing optical feedback.

Optionally, the first half active region material layer **506A** and the second half active region material layer **506B** may be used in combination with the laser device **200** (of FIG. 2) and the laser device **300** (of FIG. 3).

FIG. 6 is a schematic view of a dual output directly modulated laser device, in accordance with yet another embodiment of the present disclosure. FIG. 6 is described in conjunction with elements from FIG. 1, FIG. 2, FIG. 3, FIG. 4, and FIG. 5. With reference to FIG. 6, there is shown a dual output directly modulated laser device (hereinafter simply referred to as a laser device **600)** that includes an upper p-doped layer **602,** a lower n-doped layer **604,** an active region material layer **606A** in two outer gain sections, such as a first outer gain section **608A** and a second outer gain section **608B,** and a waveguide **606B** formed from a passive material in a central section **610.** The laser device **600** further includes two laser cavities, such as a first laser cavity formed between the central section **610** and the first laser facet **612A** and a second laser cavity formed between the central section **610** and the second laser facet **612B.** There is further shown two electrical contacts. such as a first electrical contact **614A** and second electrical contact **614B,** and two isolation trenches, such as a first isolation trench **616A** and a second isolation trench **616B.** The laser device **600** generates two directly modulated optical output signals, such as a first directly modulated optical output signal **618A** and a second directly modulated optical output signal **618B.**

Working and connections of the upper p-doped layer **602,** the lower n-doped layer **604,** the active region material layer **606A,** the first outer gain section **608A,** the second outer gain section **608B,** the first laser cavity **612A,** the second laser cavity **612B,** the first electrical contact **614A,** the second electrical contact **614B,** the first isolation trench **616A,** the second isolation trench **616B,** the first directly modulated optical output signal **618A,** and the second directly modulated optical output signal **618B,** of the laser device **600** is same that has been described in detail, for example, in FIG. 1 and hence, omitted here for the sake of brevity.

In accordance with an embodiment, the central section **610** comprises the waveguide **606B** formed from a passive material. The laser device **600** corresponds to the laser device **100** (of FIG. 1) except a difference. The difference is that, in the laser device **600,** the central section **610** comprises the waveguide **606B** formed from the passive material. In the laser device 600, the requirements on bias level accuracy of the central section **610** are relaxed by alleviating the need to stay at or below the transparency level. As a result, no electrical contact is required over the central section **610** of the laser device **600.** However, an additional epitaxial regrowth step is required to form the waveguide **606B** in the central section **610** of the laser device **600.**

Optionally, the waveguide **606B** may also be used with any of the laser devices **100, 200, 300, 400** and **500.**

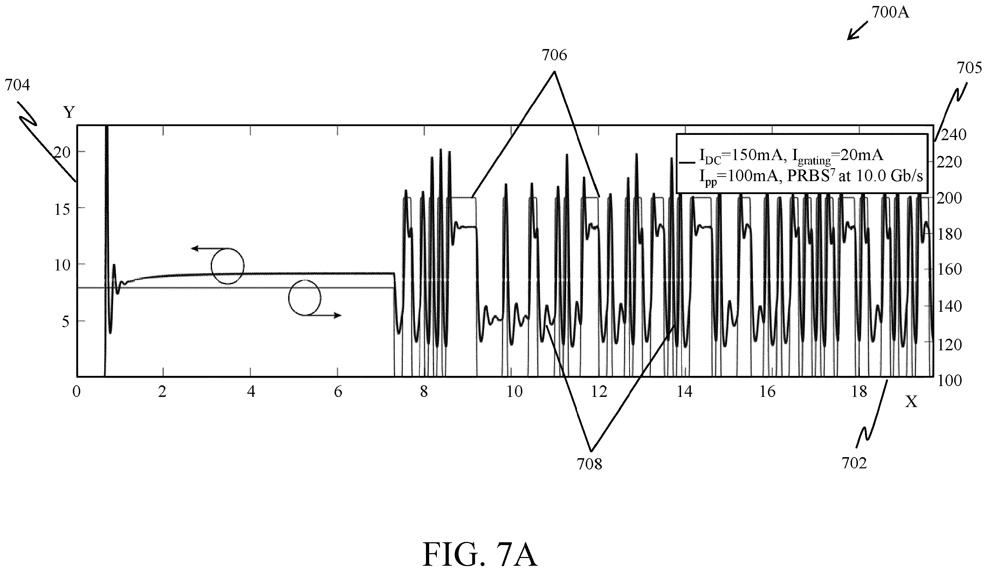

FIG. 7A is a graphical representation that depicts a temporal evolution of an optical output power of a first directly modulated optical output signal of a laser device, in accordance with an embodiment of the present disclosure. FIG. 7A is described in conjunction with elements from FIG. 1. With reference to FIG. 7A, there is shown a graphical representation **700A** that depicts a temporal evolution of the optical output power of the first directly modulated optical output signal **118A** emitted from the first laser facet **112A** of the first outer gain section **108A** of the laser device **100** (of FIG. 1).

The graphical representation **700A** is obtained by considering the laser device **100** as an asymmetric device which has the first outer gain section **108A** of length 200 micro-meter (µm), the second outer gain section **108B** of length 150 µm, and the central section **110** of length **400** µm. The first outer gain section **108A** is modulated at a data rate of 10 Gbps using a non-return-to-zero (NRZ) pseudo random binary sequence (PRBS). The NRZ PRBS is a binary sequence in which ones are represented by one significant condition, usually a positive voltage, while zeros are represented by some other significant condition, usually a negative voltage, with no other neutral or rest condition. However, the modulation data rate of the first outer gain section **108A** can be chosen flexibly, such as 1.25 Gbps, 2.5 Gbps or 25 Gbps.

The graphical representation **700A** represents time in nanoseconds (ns) on an X-axis **702** and values of optical output power in milliwatts (mW) on a Y-axis **704.** There is further shown an input current in milli-ampere (mA) on an axis **705.** A first plurality of lines **706** represents a first modulation current pattern for the first outer gain section **108A** of the laser device **100.** The first modulation current pattern indicates the first modulation current injected into the first outer gain section **108A** through the first electrical contact **114A.** A second plurality of lines **708** represents a first optical output power pattern of the first directly modulated optical output signal **118A** emitted from the first laser facet **112A** of the laser device **100.** From the graphical representation **700A,** it can be observed that an independent modulation of the first outer gain section **108A** of the laser device **100** may be obtained.

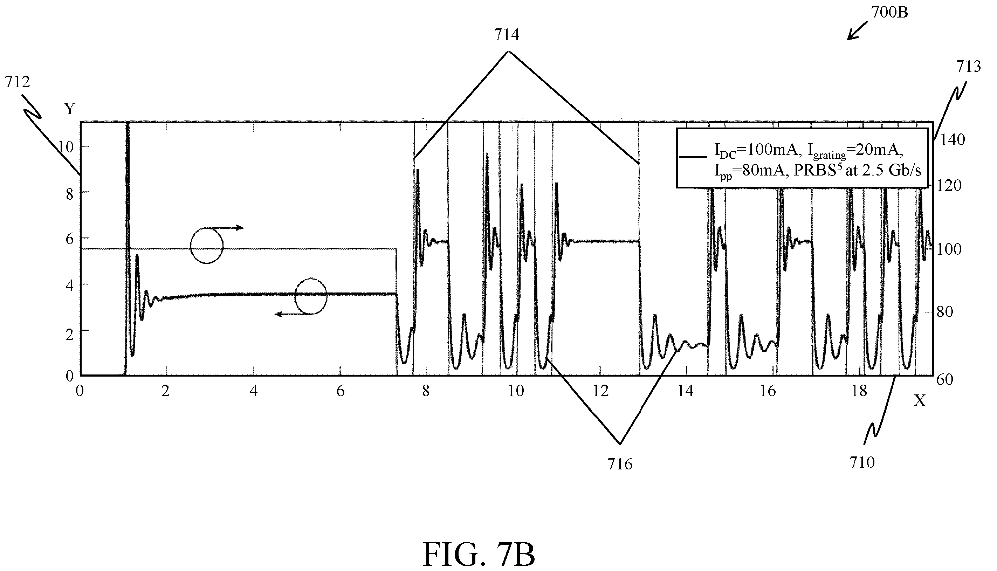

FIG. 7B is a graphical representation that depicts a temporal evolution of an optical output power of a second directly modulated optical output signal a laser device, in accordance with an embodiment of the present disclosure. FIG. 7B is described in conjunction with elements from FIG. 1 and FIG. 7A. With reference to FIG. 7B, there is shown a graphical representation **700B** that depicts a temporal evolution of the optical output power in terms of the second directly modulated optical output signal **118B** emitted from the second laser facet **112B** of the second outer gain section **108B** of the laser device **100** (of FIG. 1).

Similar to the graphical representation **700A,** the graphical representation **700B** is obtained by considering the laser device 100 as an asymmetric device which has the first outer gain section **108A** of length 200 micro-meter (µm), the second outer gain section **108B** of length 150 µm and the central section **110** of length 400 µm. The second outer gain section **108B** is modulated at a data rate of 2.5 Gbps using the non-return-to-zero (NRZ) pseudo random binary sequence (PRBS). However, the modulation data rate of the second outer gain section **108B** can be chosen flexibly, such as 1.25 Gbps, 2.5 Gbps or 10 Gbps.

The graphical representation **700B** represents time in nanoseconds (ns) on an X-axis **710** and values of output optical power in mW on a Y-axis **712.** There is further shown an input current in mA on an axis **713.** A first plurality of lines **714** represents a second modulation current pattern for the second outer gain section **108B** of the laser device **100.** The second modulation current pattern indicates the second modulation current injected into the second outer gain section **108B** through the second electrical contact **114B.** A second plurality of lines **716** represents a second optical output power pattern of the second directly modulated optical output signal **118B** emitted from the second laser facet **112B** of the laser device **100.** From the graphical representation **700B,** it can be observed that an independent modulation of the second outer gain section **108B** of the laser device **100** may be obtained.

Each of the graphical representations **700A** and **700B** is obtained by considering the first outer gain section **108A,** the second outer gain section **108B,** and the central section **110** of different lengths and with refractive index differences also. For example, the refractive index differences Δ*n* of 0.005, 0.01 and 0.01 are chosen for the first outer gain section **108A,** the central section **110,** and the second outer gain section **108B,** respectively. The refractive index differences result into different grating coupling coefficients of 63 cm⁻¹ and 127 cm⁻¹. Each of the first outer gain section **108A** and the second outer gain section **108B** is biased at individual DC and peak-to-peak current swings to yield different levels of the optical output power at each facet. For example, in the graphical representation **700A,** each of the first outer gain section **108A** and the second outer gain section **108B** is biased at I_{DC} of 150 mA and Iₚₚ of 100 mA. Similarly, in the graphical representation **700B,** each of the first outer gain section **108A** and the second outer gain section **108B** is biased at I_{DC} of 100 mA and Iₚₚ of 80 mA. From each of the graphical representations **700A** and **700B,** it can be observed that the first directly modulated optical output signal **118A** and the second directly modulated optical output signal **118B** follow their injection modulation currents after an initial warm-up time. In comparison to the first directly modulated optical output signal **118A** emitted from the first laser cavity **112A** of the first outer gain section **108A** (i.e., channel 1) in the graphical representation **700A,** the second directly modulated optical output signal **118B** emitted from the second laser cavity **112B** of the second outer gain section **108B** (i.e., channel 2) in the graphical representation **700B,** follows the slightly more strongly pronounced residual oscillations with respect to zero levels. However, despite of having different optical power associated with the first directly modulated optical output signal **118A** and the second directly modulated optical output signal **118B,** an independent modulation of each of the first outer gain section **108A** and the second outer gain section **108B** may be obtained. In the laser device **100** (i.e., asymmetric device), undesired oscillations can be filtered out by use of a respective lower-speed receiver.

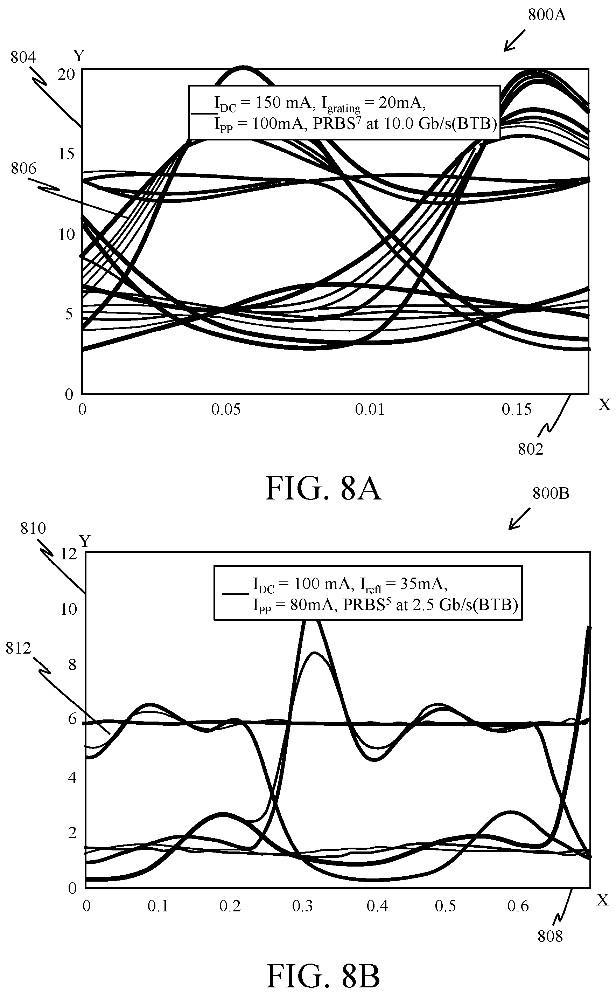

FIG. 8A is a graphical representation that depicts an eye diagram of a first directly modulated optical output signal of a laser device, in accordance with an embodiment of the present disclosure. FIG. 8A is described in conjunction with elements from FIG. 1. With reference to FIG. 8A, there is shown a graphical representation **800A** that depicts an eye diagram of the first directly modulated optical output signal **118A** of the laser device **100.**

The graphical representation **800A** represents relative time in nanoseconds (ns) on an X-axis **802** and values of optical signal in milliwatts (mW) on a Y-axis **804.** There is further shown an eye diagram **806** of the first directly modulated optical output signal **118A.** The first directly modulated optical output signal **118A** is obtained by modulating the first outer gain section **108A** (i.e., channel 1) at a data rate of 10 Gbps using the NRZ PRBS generator.

FIG. 8B is a graphical representation that depicts an eye diagram of a second directly modulated optical output signal of a laser device, in accordance with an embodiment of the present disclosure. FIG. 8B is described in conjunction with elements from FIG. 1 and FIG. 8A. With reference to FIG. 8B, there is shown a graphical representation **800B** that depicts an eye diagram of the second directly modulated optical output signal **118B** of the laser device **100.**

The graphical representation **800B** represents relative time in nanoseconds (ns) on an X-axis **808** and values of optical signal in milliwatts (mW) on a Y-axis **810.** There is further shown an eye diagram **812** of the second directly modulated optical output signal **118B.** The second directly modulated optical output signal **118B** is obtained by modulating the second outer gain section **108B** (i.e., channel 2) at a data rate of 2.5 Gbps using the NRZ PRBS generator.

Each of the eye diagrams **806** (of FIG. 8A) and **812** (of FIG. 8B) is obtained by considering the laser device **100** as an asymmetric device which has the first outer gain section **108A** of length 200 micro-meter (µm), the second outer gain section **108B** of length 150 µm and the central section **110** of length 400 µm. Each of the eye diagrams **806** and **812** demonstrate that the level of optical output power of the first directly modulated optical output signal **118A** and the second directly modulated optical output signal **118B** can be regulated through the design and biasing of each of the first outer gain section **108A,** the second outer gain section **108B** and the central section **110** of the laser device **100.** This further results into elimination of optical attenuators at an optical link (e.g., a sub-PON) in an optical network architecture. Moreover, depending on bias conditions of each of three independent sections (i.e., the first outer gain section **108A,** the second outer gain section **108B** and the central section **110)** of the laser device **100,** an approximate electrical power savings of 30% may be achieved in comparison to a conventional DFB DML device where two conventional laser devices are biased at same level.

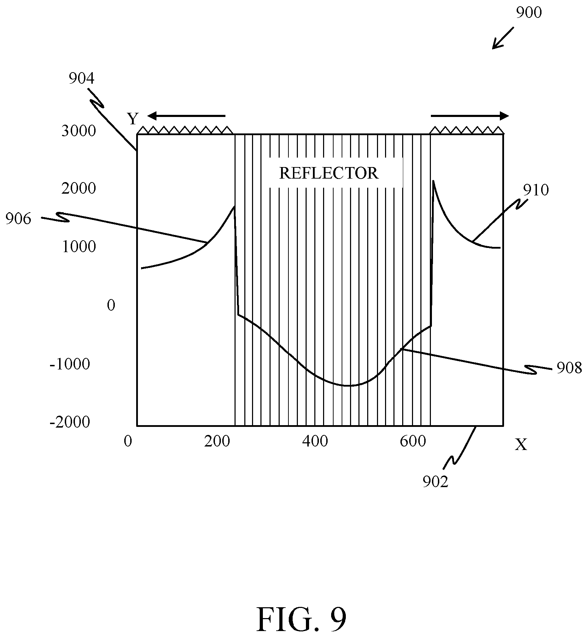

FIG. 9 is a graphical representation that depicts distribution of an optical gain in each section of a laser device, in accordance with an embodiment of the present disclosure. FIG. 9 is described in conjunction with elements from FIG. 1. With reference to FIG. 9, there is shown a graphical representation **900** that depicts distribution of an optical gain in the first outer gain section **108A,** the central section **110,** and the second outer gain section **108B** of the laser device **100** (of FIG. 1).

The graphical representation **900** represents longitudinal position of each of the first outer gain section **108A,** the second outer gain section **108B,** and the central section **110** in micrometres (µm) on an X-axis **902** and values of optical gain in per centimetre (cm⁻¹) on a Y-axis **904.** A first optical gain curve 906 represents the optical gain obtained in the first outer gain section **108A.** A second optical gain curve **908** represents the optical gain obtained in the central section **110.** A third optical gain curve **910** represents the optical gain obtained in the second outer gain section **108B.** From the first optical gain curve **906,** the third optical gain curve **910** and the second optical gain curve **908,** it can be observed that the optical gain distribution is positive in the two outer gain sections, such as the first outer gain section **108A** and the second outer gain section **108B,** while the optical gain distribution falls below zero in the central section **110,** respectively.

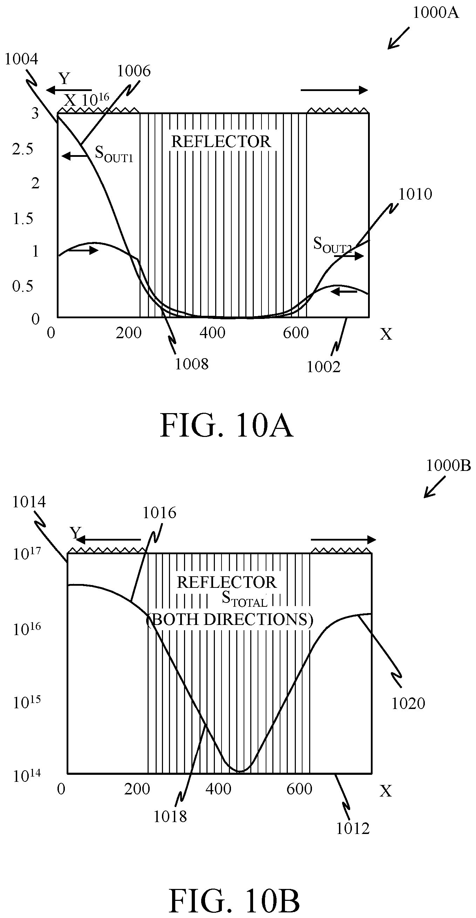

FIG. 10A is a graphical representation that depicts distribution of a photon density in each section of a laser device on a linear scale, in accordance with an embodiment of the present disclosure. FIG. 10A is described in conjunction with elements from FIG. 1. With reference to FIG. 10A, there is shown a graphical representation **1000A** that depicts distribution of a photon density on a linear scale in the first outer gain section **108A,** the second outer gain section **108B** and the central section **110** of the laser device **100** (of FIG. 1).

The graphical representation **1000A** represents longitudinal position of each of the first outer gain section **108A,** the second outer gain section **108B,** and the central section **110** in µm on an X-axis **1002** and values of photon density in per cubic centimetre (cm⁻³) on a Y-axis **1004.** A first photon density curve **1006** represents the photon density in the first outer gain section **108A** on a linear scale. A second photon density curve **1008** represents the photon density in the central section **110** on the linear scale. A third photon density curve **1010** represents the photon density in the second outer gain section **108B** on the linear scale. From the first photon density curve **1006** and the third photon density curve **1010,** it can be observed that the photon density distribution experiences amplification at different rates in the two outer gain sections, such as the first outer gain section **108A** and the second outer gain section **108B.** This further illustrates that the biasing level of each of the first outer gain section **108A** and the second outer gain section **108B** can be adjusted to yield different optical output power of the first directly modulated optical output signal **118A** and the second directly modulated optical output signal **118B.** Moreover, the second photon density curve **1008** indicates a reduced photon density distribution in the central section **110.** This happens because of low biasing only of the central section **110,** because the central section **110** serves as passive reflector only. The low biasing is performed to avoid crosstalk between uncorrelated photons from the central section **110** and the two optical modulation signals from the outer gain sections **108A** and **108B,** while excess absorption loss in the central section **110** is reduced.

FIG. 10B is a graphical representation that depicts distribution of a photon density in each section of a laser device on a logarithmic scale, in accordance with an embodiment of the present disclosure. FIG. 10B is described in conjunction with elements from FIG. 1 and FIG. 10A. With reference to FIG. 10B, there is shown a graphical representation **1000B** that depicts distribution of a photon density on a logarithmic scale in the first outer gain section **108A,** the second outer gain section **108B,** and the central section **110** of the laser device **100** (of FIG. 1).

The graphical representation **1000B** represents longitudinal position of each of the first outer gain section **108A,** the second outer gain section **108B,** and the central section **110** in µm on an X-axis **1012** and values of photon density in cm⁻³ on a Y-axis **1014.** A first photon density curve **1016** represents the photon density in the first outer gain section **108A** on a logarithmic scale. A second photon density curve **1018** represents the photon density in the central section **110** on the logarithmic scale. A third photon density curve **1020** represents the photon density in the second outer gain section **108B** on the logarithmic scale. From the first photon density curve **1016** and the third photon density curve **1020,** it can be observed that the photon density distribution experiences amplification at different rates in the two outer gain sections, such as the first outer gain section **108A** and the second outer gain section **108B.** This further illustrates that the biasing level of each of the first outer gain section **108A** and the second outer gain section **108B** can be adjusted to yield different optical output power of the first directly modulated optical output signal **118A** and the second directly modulated optical output signal **118B.** Moreover, the second photon density curve **1018** indicates a reduced photon density distribution (e.g., a reduction of two orders of magnitude) in the central section **110.** This happens because of low biasing only of the central section **110,** because the central section **110** serves as passive reflector only. The low biasing is performed to avoid crosstalk between uncorrelated photons from the central section **110** and the two optical modulation signals from the outer gain sections **108A** and **108B,** while excess absorption loss in the central section **110** is reduced.

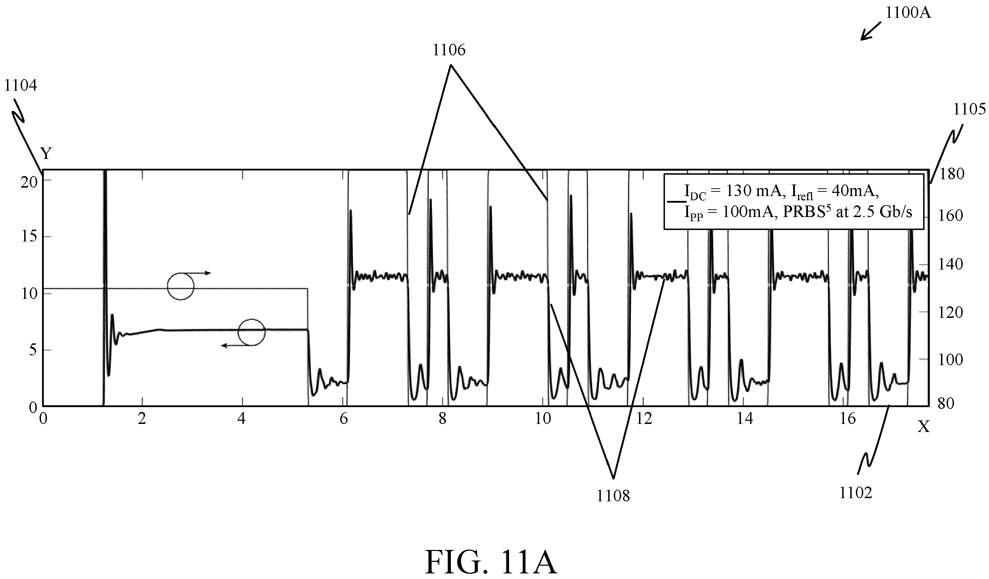

FIG. 11A is a graphical representation that depicts a temporal evolution of an optical output power of a first directly modulated optical output signal of a laser device, in accordance with another embodiment of the present disclosure. FIG. 11A is described in conjunction with elements from FIG. 2. With reference to FIG. 11A, there is shown a graphical representation **1100A** that depicts a temporal evolution of the optical output power of the first directly modulated optical output signal **218A** emitted from the first laser facet **212A** of the first outer gain section **208A** of the laser device **200** (of FIG. 2).

The graphical representation **1100A** is obtained by considering the laser device **200** as a symmetric device which has the first outer gain section **208A** of length 300 µm, the second outer gain section **208B** of length 300 µm, and the central section **210** of length 400 µm. The first outer gain section **208A** is modulated at a data rate of 2.5 Gbps using a non-return-to-zero (NRZ) pseudo random binary sequence (PRBS).

The graphical representation **1100A** represents time in nanoseconds (ns) on an X-axis **1102** and values of optical output power in milliwatts (mW) on a Y-axis **1104.** There is further shown an input current in milli-ampere (mA) on an axis **1105.** A first plurality of lines **1106** represents a first modulation current pattern for the first laser cavity **212A** of the first outer gain section **208A** of the laser device **200.** The first modulation current pattern indicates the first modulation current injected into the first outer gain section **208A** through the first electrical contact **214A.** A second plurality of lines **1108** represents a first optical output power pattern of the first directly modulated optical output signal **218A** emitted from the first laser cavity **212A** of the laser device **200.** From the graphical representation **1100A,** it can be observed that an independent modulation of the first outer gain section **208A** of the laser device **200** may be obtained.

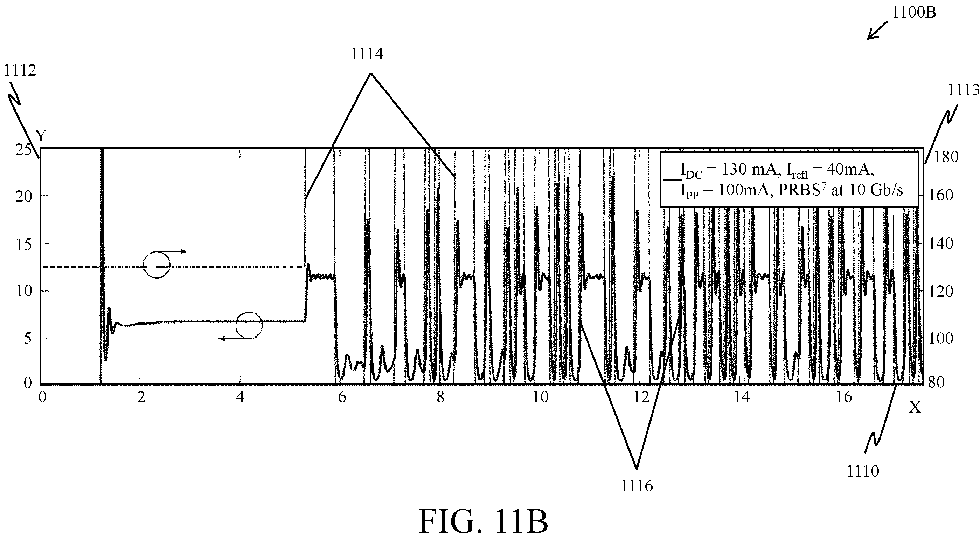

FIG. 11B is a graphical representation that depicts a temporal evolution of an optical output power of a second directly modulated optical output signal a laser device, in accordance with another embodiment of the present disclosure. FIG. 11B is described in conjunction with elements from FIG. 2 and FIG. 11A. With reference to FIG. 11B, there is shown a graphical representation **1100B** that depicts a temporal evolution of the optical output power of the second directly modulated optical output signal **218B** emitted from the second laser facet **212B** of the second outer gain section **208B** of the laser device **200** (of FIG. 2).

Similar to the graphical representation **1100A,** the graphical representation **1100B** is obtained by considering the laser device **200** as a symmetric device which has the first outer gain section **208A** of length 300 µm, the second outer gain section **208B** of length 300 µm and the central section **210** of length 400 µm. The second outer gain section **208B** is modulated at a data rate of 10 Gbps using the non-return-to-zero (NRZ) pseudo random binary sequence (PRBS).

The graphical representation **1100B** represents time in ns on an X-axis **1110** and values of output optical power in mW on a Y-axis **1112.** There is further shown an input current in mA on an axis **1113.** A first plurality of lines **1114** represents a second modulation current pattern for the second laser cavity **212B** of the second outer gain section **208B** of the laser device **200.** The second modulation current pattern indicates the second modulation current injected into the second outer gain section **208B** through the second electrical contact **214B.** A second plurality of lines **1116** represents a second optical output power pattern of the second directly modulated optical output signal **218B** emitted from the second laser facet **212B** of the laser device **200.** From the graphical representation **1100B,** it can be observed that an independent modulation of the second outer gain section **208B** of the laser device **200** may be obtained.

Each of the graphical representations **1100A** and **1100B** is obtained by considering the first outer gain section **208A** and the second outer gain section **208B** of same lengths and with same refractive index also. For example, the refractive index differences Δ*n* of 0.005, 0.01, and 0.005 are chosen for the first outer gain section **208A,** the central section **210,** and the second outer gain section **208B,** respectively. The same refractive index (i.e., Δ*n* = 0.005) of each of the first outer gain section **208A** and the second outer gain section **208B** result into same grating coupling coefficients of 63 cm⁻¹. Similarly, the refractive index (i.e., Δ*n* = 0.01) of the central section **210** result into a grating coupling coefficient of 127 cm⁻¹. Each of the first outer gain section **208A** and the second outer gain section **208B** is biased under identical DC and peak-to-peak current swings to yield approximately equal levels of the optical output power at each facet. For example, in the graphical representation **1100A,** each of the first outer gain section **208A** and the second outer gain section **208B** is biased at I_{DC} of 130 mA and Iₚₚ of 100 mA. Similarly, in the graphical representation **1100B,** each of the first outer gain section **208A** and the second outer gain section **208B** is biased at I_{DC} of 130 mA and Iₚₚ of 100 mA. From each of the graphical representations **1100A** and **1100B,** it can be observed that with approximately equal optical power associated with the first directly modulated optical output signal **218A** and the second directly modulated optical output signal **218B,** an independent modulation of each of the first outer gain section **208A** and the second outer gain section **208B** may be obtained.

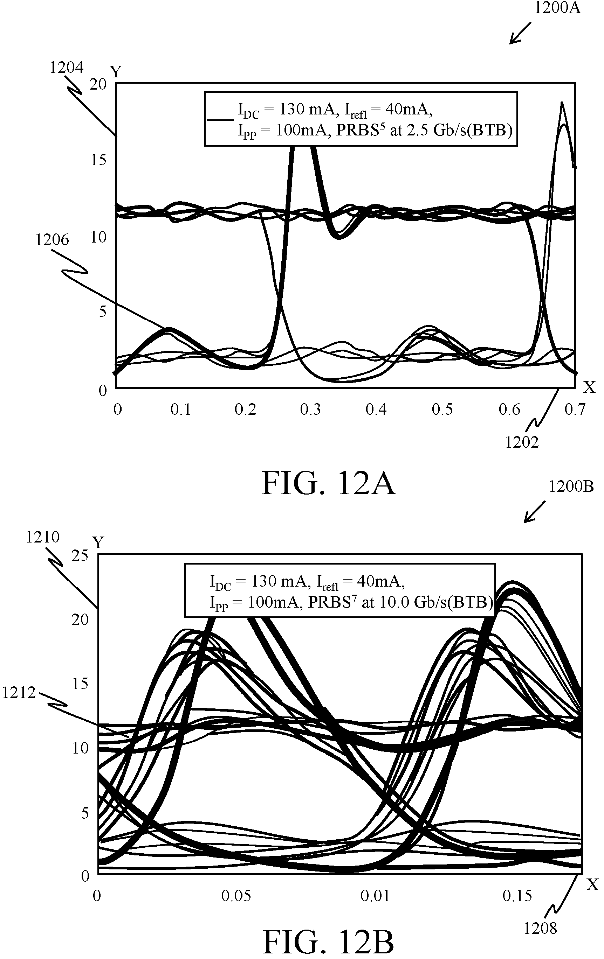

FIG. 12A is a graphical representation that depicts an eye diagram of a first directly modulated optical output signal of a laser device, in accordance with another embodiment of the present disclosure. FIG. 12A is described in conjunction with elements from FIGs. 2, 11A and 11B. With reference to FIG. 12A, there is shown a graphical representation **1200A** that depicts an eye diagram of the first directly modulated optical output signal **218A** of the laser device **200.**

The graphical representation **1200A** represents relative time in ns on an X-axis **1202** and values of optical signal in mW on a Y-axis **1204.** There is further shown an eye diagram **1206** of the first directly modulated optical output signal **218A.** The first directly modulated optical output signal **218A** is obtained by modulating the first outer gain section **208A** (i.e., channel 1) at a data rate of 2.5 Gbps using the NRZ PRBS generator.

FIG. 12B is a graphical representation that depicts an eye diagram of a second directly modulated optical output signal of a laser device, in accordance with another embodiment of the present disclosure. FIG. 12B is described in conjunction with elements from FIGs. 2, 11A, 11B, and 12A. With reference to FIG. 12B, there is shown a graphical representation **1200B** that depicts an eye diagram of the second directly modulated optical output signal **218B** of the laser device **200.**

The graphical representation **1200B** represents relative time in ns on an X-axis **1208** and values of optical signal in mW on a Y-axis **1210.** There is further shown an eye diagram **1212** of the second directly modulated optical output signal **218B.** The second directly modulated optical output signal **218B** is obtained by modulating the second outer gain section **208B** (i.e., channel 2) at a data rate of 10 Gbps using the NRZ PRBS generator.

Each of the eye diagrams **1206** (of FIG. 12A) and **1212** (of FIG. 12B) is obtained by considering the laser device **200** as a symmetric device which has the first outer gain section **208A** of length 300 µm, the second outer gain section **208B** of length 300 µm and the central section **210** of length 400 µm. Each of the eye diagrams **1206** and **1212** demonstrate that the eyes of both the first directly modulated optical output signal **218A** the second directly modulated optical output signal **218B,** show a clear eye opening.

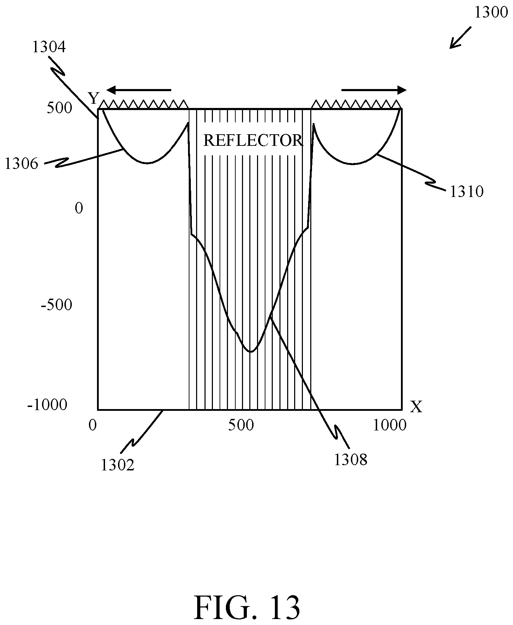

FIG. 13 is a graphical representation that depicts distribution of an optical gain in each section of a laser device, in accordance with another embodiment of the present disclosure. FIG. 13 is described in conjunction with elements from FIG. 2. With reference to FIG. 13, there is shown a graphical representation **1300** that depicts distribution of an optical gain in the first outer gain section **208A,** the central section **210,** and the second outer gain section **208B** of the laser device **200** (of FIG. 2).

The graphical representation **1300** represents longitudinal position of each of the first outer gain section **208A,** the second outer gain section **208B,** and the central section **210** in µm on an X-axis **1302** and values of optical gain in cm⁻¹ on a Y-axis **1304.** A first optical gain curve **1306** represents the optical gain obtained in the first outer gain section **208A.** A second optical gain curve **1308** represents the optical gain obtained in the central section **210.** A third optical gain curve **1310** represents the optical gain obtained in the second outer gain section **208B.** From the first optical gain curve **1306,** the third optical gain curve **1310** and the second optical gain curve **1308,** it can be observed that the optical gain distribution is positive in the two outer gain sections, such as the first outer gain section **208A** and the second outer gain section **208B,** while the optical gain distribution falls below zero in the central section **210,** respectively. Moreover, the first optical curve **1306** and the third optical curve **1310** show a symmetric behaviour as a result of the symmetric cavity design and bias conditions.

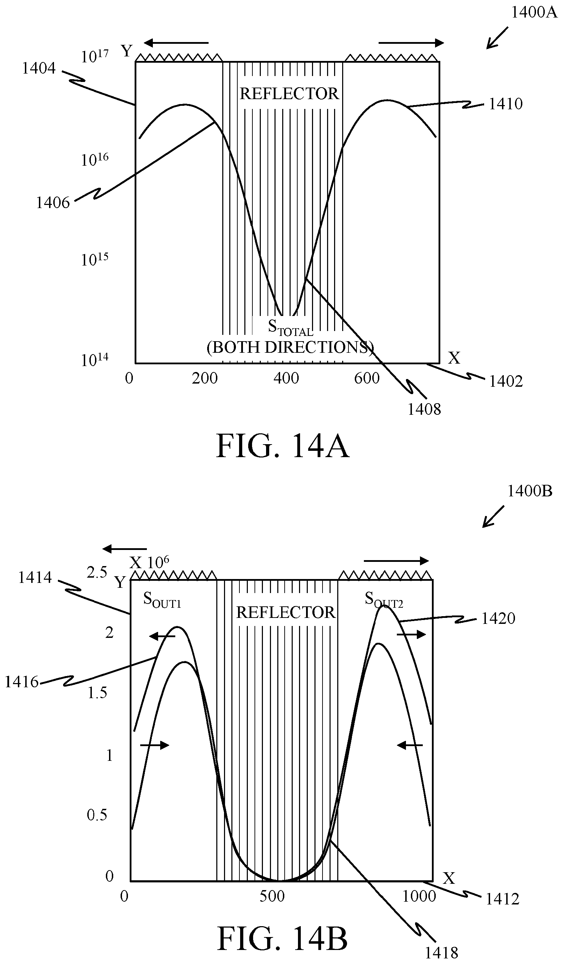

FIG. 14A is a graphical representation that depicts distribution of a photon density in each section of a laser device on a linear scale, in accordance with another embodiment of the present disclosure. FIG. 14A is described in conjunction with elements from FIG. 2. With reference to FIG. 14A, there is shown a graphical representation **1400A** that depicts distribution of a photon density on a linear scale in the first outer gain section **208A,** the second outer gain section **208B** and the central section **210** of the laser device **200** (of FIG. 2).

The graphical representation **1400A** represents longitudinal position of each of the first outer gain section **208A,** the second outer gain section **208B,** and the central section **210** in µm on an X-axis **1402** and values of photon density in cm⁻³ on a Y-axis **1404.** A first photon density curve **1406** represents the photon density in the first outer gain section **208A** on a linear scale. A second photon density curve **1408** represents the photon density in the central section **210** on the linear scale. A third photon density curve **1410** represents the photon density in the second outer gain section **208B** on the linear scale. From the first photon density curve **1406** and the third photon density curve **1410,** it can be observed that the photon density distribution experiences amplification in the two outer gain sections, such as the first outer gain section **208A** and the second outer gain section **208B.** Moreover, the first photon density curve **1406** and the third photon density curve **1410** show a symmetric behaviour as a result of the symmetric cavity design and bias conditions. However, the second photon density curve **1408** indicates a reduced photon density distribution in the central section **210.** This happens because of only low biasing of the central section **210,** because the central section **210** serves as passive reflector only. The low biasing is performed to avoid crosstalk between uncorrelated photons from the central section **210** and the two optical modulation signals from the outer gain sections **208A** and **208B,** while excess absorption loss in the central section **210** is reduced.

FIG. 14B is a graphical representation that depicts distribution of a photon density in each section of a laser device on a logarithmic scale, in accordance with another embodiment of the present disclosure. FIG. 14B is described in conjunction with elements from FIG. 2 and FIG. 14A. With reference to FIG. 14B, there is shown a graphical representation **1400B** that depicts distribution of a photon density on a logarithmic scale in the first outer gain section **208A,** the second outer gain section **208B,** and the central section **210** of the laser device **200** (of FIG. 2).

The graphical representation **1400B** represents longitudinal position of each of the first outer gain section **208A,** the second outer gain section **208B,** and the central section **210** in µm on an X-axis **1412** and values of photon density in cm⁻³ on a Y-axis **1414.** A first photon density curve **1416** represents the photon density in the first outer gain section **208A** on a logarithmic scale. A second photon density curve **1418** represents the photon density in the central section **210** on the logarithmic scale. A third photon density curve **1420** represents the photon density in the second outer gain section **208B** on the logarithmic scale. From the first photon density curve **1416** and the third photon density curve **1420,** it can be observed that the photon density distribution experiences amplification in the two outer gain sections, such as the first outer gain section **208A** and the second outer gain section **208B.** Moreover, the first photon density curve **1416** and the third photon density curve **1420** show a symmetric behaviour as a result of the symmetric cavity design and bias conditions. However, the second photon density curve **1418** indicates a reduced photon density distribution (e.g., a reduction of two orders of magnitude) in the central section **210.** This happens because of only low biasing of the central section **210,** because the central section **210** serves as passive reflector only. The low biasing is performed to avoid crosstalk between uncorrelated photons from the central section **210** and the two optical modulation signals from the outer gain sections **208A** and **208B,** while excess absorption loss in the central section **210** is reduced.

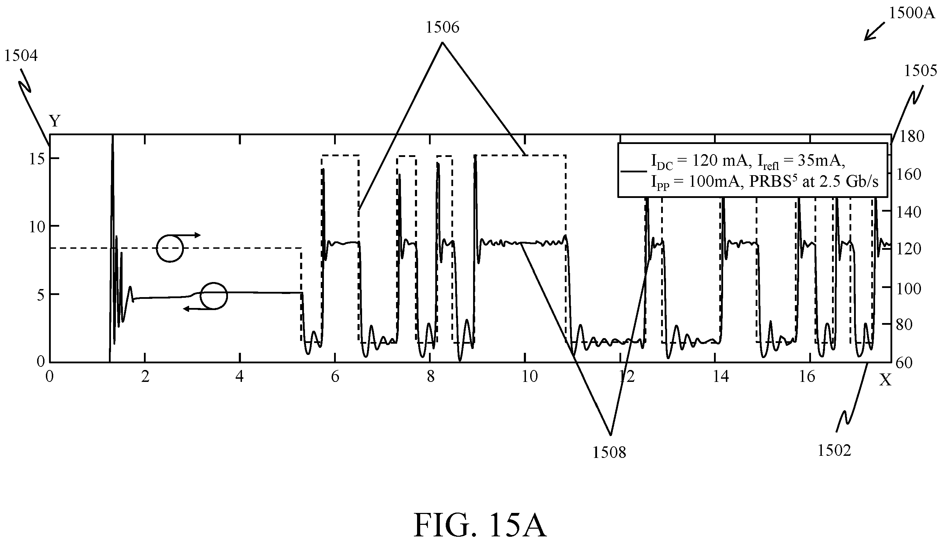

FIG. 15A is a graphical representation that depicts a temporal evolution of an optical output power of a first directly modulated optical output signal of a laser device, in accordance with yet another embodiment of the present disclosure. FIG. 15A is described in conjunction with elements from FIG. 3. With reference to FIG. 15A, there is shown a graphical representation **1500A** that depicts a temporal evolution of the optical output power of the first directly modulated optical output signal **318A** emitted from the first laser facet **312A** of the first outer gain section **308A** of the laser device **300** (of FIG. 3).

The graphical representation **1500A** is obtained by considering the laser device **300** as a symmetric device which has the first outer gain section **308A** of length 160 µm, the second outer gain section **308B** of length 160 µm, and the central section **310** of length 500 µm. The first outer gain section **308A** is modulated at a data rate of 2.5 Gbps using a non-return-to-zero (NRZ) pseudo random binary sequence (PRBS).

The graphical representation **1500A** represents time in nanoseconds (ns) on an X-axis **1502** and values of optical output power in milliwatts (mW) on a Y-axis **1504.** There is further shown an input current in milli-ampere (mA) on an axis **1505.** A first plurality of lines **1506** represents a first modulation current pattern for the first outer gain section **308A** of the laser device **300.** The first modulation current pattern indicates the first modulation current injected into the first outer gain section **308A** through the first electrical contact **314A.** A second plurality of lines **1508** represents a first optical output power pattern of the first directly modulated optical output signal **318A** emitted from the first laser facet **312A** of the laser device **300.** From the graphical representation **1500A,** it can be observed that an independent modulation of the first outer gain section **308A** of the laser device **300** may be obtained.

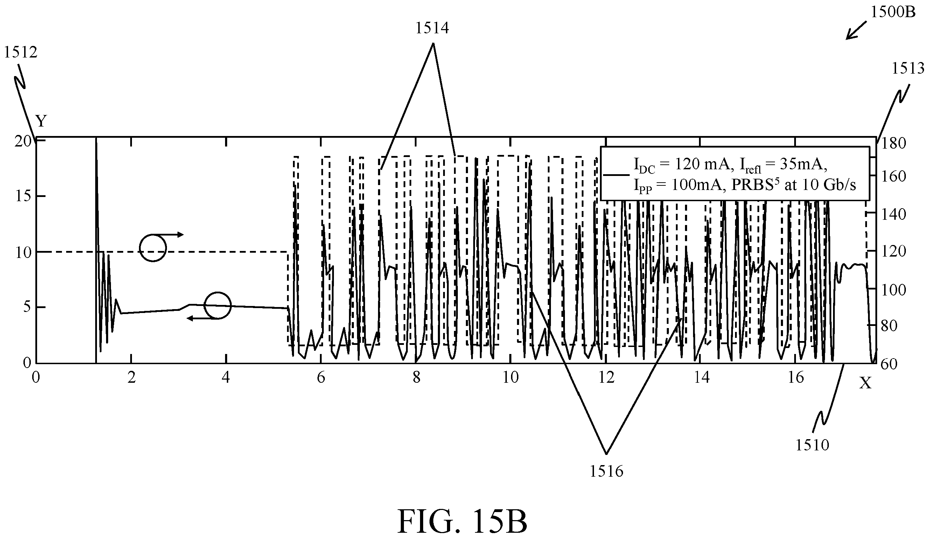

FIG. 15B is a graphical representation that depicts a temporal evolution of an optical output power of a second directly modulated optical output signal a laser device, in accordance with yet another embodiment of the present disclosure. FIG. 15B is described in conjunction with elements from FIG. 3 and FIG. 15A. With reference to FIG. 15B, there is shown a graphical representation **1500B** that depicts a temporal evolution of the optical output power in terms of the second directly modulated optical output signal **318B** emitted from the second laser facet **312B** of the second outer gain section **308B** of the laser device **300** (of FIG. 3).

Similar to the graphical representation **1500A,** the graphical representation **1500B** is obtained by considering the laser device 300 as a symmetric device which has the first outer gain section **308A** of length 160 µm, the second outer gain section **308B** of length 160 µm and the central section **310** of length 500 µm. The second outer gain section **308B** is modulated at a data rate of 10 Gbps using the non-return-to-zero (NRZ) pseudo random binary sequence (PRBS). However, the modulation data rate of the second outer gain section **308B** can be chosen flexibly, such as 1.25 Gbps, 2.5 Gbps or 25 Gbps.

The graphical representation **1500B** represents time in ns on an X-axis **1510** and values of output optical power in mW on a Y-axis **1512.** There is further shown an input current in mA on an axis **1513.** A first plurality of lines **1514** represents a second modulation current pattern for the second outer gain section **308B** of the laser device **300.** The second modulation current pattern indicates the second modulation current injected into the second outer gain section **308B** through the second electrical contact **314B.** A second plurality of lines **1516** represents a second optical output power pattern of the second directly modulated optical output signal **318B** emitted from the second laser output facet **312B** of the laser device **300.** From the graphical representation **1500B,** it can be observed that an independent modulation of the second outer gain section **308B** of the laser device **300** may be obtained.

Each of the graphical representations **1500A** and **1500B** is obtained by considering the first outer gain section **308A** and the second outer gain section **308B** of same lengths and without grating. Each of the first outer gain section **308A** and the second outer gain section **308B** is biased under identical DC and peak-to-peak conditions to yield approximately equal levels of the optical output power at each facet. For example, in the graphical representation **1500A,** each of the first outer gain section **308A** and the second outer gain section **308B** is biased at I_{DC} of 120 mA and Iₚₚ of 100 mA. Similarly, in the graphical representation **1500B,** each of the first outer gain section **308A** and the second outer gain section **308B** is biased at I_{DC} of 120 mA and Iₚₚ of 100 mA. From each of the graphical representations **1500A** and **1500B,** it can be observed that with approximately equal optical power associated with the first directly modulated optical output signal **318A** and the second directly modulated optical output signal **318B,** an independent modulation of each of the first outer gain section **308A** and the second outer gain section 308B may be obtained with Fabry-Perot-type cavities without grating.

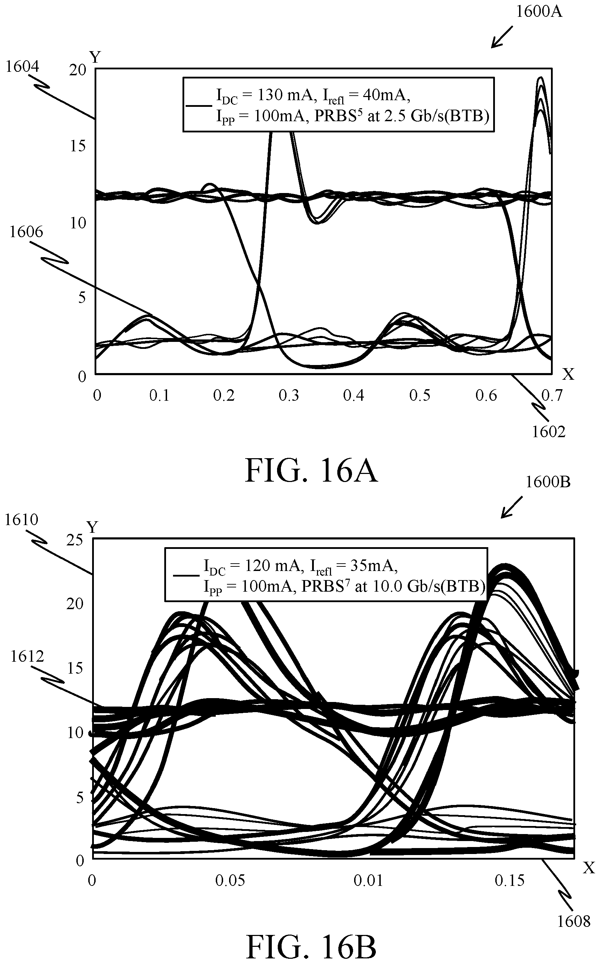

FIG. 16A is a graphical representation that depicts an eye diagram of a first directly modulated optical output signal of a laser device, in accordance with yet another embodiment of the present disclosure. FIG. 16A is described in conjunction with elements from FIG. 3. With reference to FIG. 16A, there is shown a graphical representation **1600A** that depicts an eye diagram of the first directly modulated optical output signal **318A** of the laser device **300.**

The graphical representation **1600A** represents relative time in ns on an X-axis **1602** and values of optical signal in mW on a Y-axis **1604.** There is further shown an eye diagram **1606** of the first directly modulated optical output signal **318A.** The first directly modulated optical output signal **318A** is obtained by modulating the first outer gain section **308A** (i.e., channel 1) at a data rate of 2.5 Gbps using the NRZ PRBS generator.

FIG. 16B is a graphical representation that depicts an eye diagram of a second directly modulated optical output signal of a laser device, in accordance with yet another embodiment of the present disclosure. FIG. 16B is described in conjunction with elements from FIG. 3 and FIG. 16A. With reference to FIG. 16B, there is shown a graphical representation **1600B** that depicts an eye diagram of the second directly modulated optical output signal **318B** of the laser device **300.**

The graphical representation **1600B** represents relative time in ns on an X-axis **1608** and values of optical signal in mW on a Y-axis **1610.** There is further shown an eye diagram **1612** of the second directly modulated optical output signal **318B.** The second directly modulated optical output signal **318B** is obtained by modulating the second second outer gain section **308B** (i.e., channel 2) at a data rate of 10 Gbps using the NRZ PRBS generator.

Each of the eye diagrams 1606 (of FIG. 16A) and **1612** (of FIG. 16B) is obtained by considering the laser device **300** as a symmetric device which has the first outer gain section **308A** of length 160 µm, the second outer gain section **308B** of length 160 µm and the central section **310** of length 500 µm. Each of the eye diagrams **1606** and **1612** demonstrate that the eyes of both the first directly modulated optical output signal **318A** the second directly modulated optical output signal **318B,** show a clear eye opening.

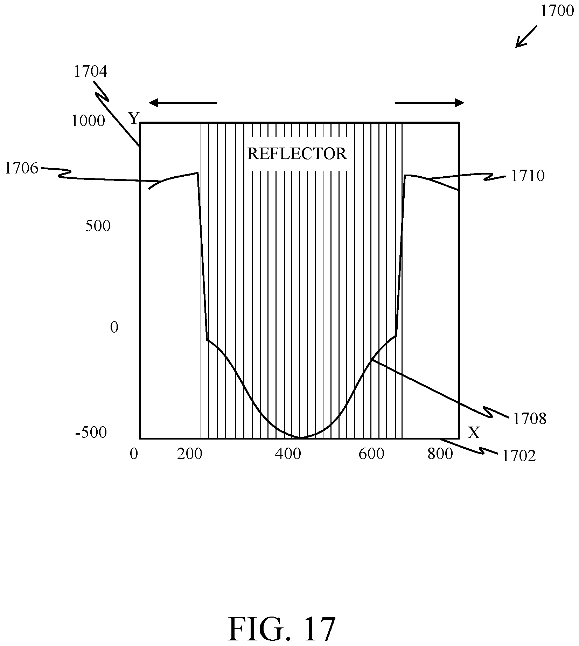

FIG. 17 is a graphical representation that depicts distribution of an optical gain in each section of a laser device, in accordance with yet another embodiment of the present disclosure. FIG. 17 is described in conjunction with elements from FIG. 3. With reference to FIG. 17, there is shown a graphical representation **1700** that depicts distribution of an optical gain in the first outer gain section **308A,** the central section **310,** and the second outer gain section **308B** of the laser device **300** (of FIG. 3).

The graphical representation **1700** represents longitudinal position of each of the first outer gain section **308A,** the second outer gain section **308B,** and the central section **310** in µm on an X-axis **1702** and values of optical gain in cm⁻¹ on a Y-axis **1704.** A first optical gain curve **1706** represents the optical gain obtained in the first outer gain section **308A.** A second optical gain curve **1708** represents the optical gain obtained in the central section **310.** A third optical gain curve **1710** represents the optical gain obtained in the second outer gain section **308B.** From the first optical gain curve **1706,** the third optical gain curve **1710** and the second optical gain curve **1708,** it can be observed that the optical gain distribution is positive in the two outer gain sections, such as the first outer gain section **308A** and the second outer gain section **308B,** while the optical gain distribution falls below zero in the central section **310,** respectively. Moreover, the first optical curve **1706** and the third optical curve **1710** show a symmetric behaviour as a result of the symmetric cavity design and bias conditions.

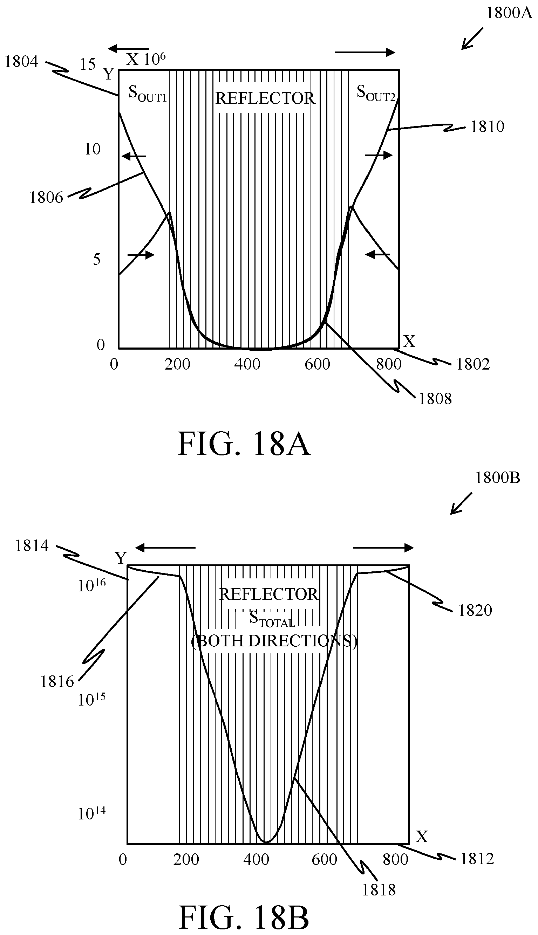

FIG. 18A is a graphical representation that depicts distribution of a photon density in each section of a laser device on a linear scale, in accordance with yet another embodiment of the present disclosure. FIG. 18A is described in conjunction with elements from FIG. 3. With reference to FIG. 18A, there is shown a graphical representation **1800A** that depicts distribution of a photon density on a linear scale in the first outer gain section **308A,** the second outer gain section **308B** and the central section **310** of the laser device 300 (of FIG. 3).

The graphical representation **1800A** represents longitudinal position of each of the first outer gain section **308A,** the second outer gain section **308B,** and the central section **310** in µm on an X-axis **1802** and values of photon density in cm⁻³ on a Y-axis **1804.** A first photon density curve **1806** represents the photon density in the first outer gain section **308A** on a linear scale. A second photon density curve **1808** represents the photon density in the central section **310** on the linear scale. A third photon density curve **1810** represents the photon density in the second outer gain section **308B** on the linear scale. From the first photon density curve **1806** and the third photon density curve **1810,** it can be observed that the photon density distribution experiences amplification in the two outer gain sections, such as the first outer gain section **308A** and the second outer gain section **308B.** Moreover, the first photon density curve **1806** and the third photon density curve **1810** show a symmetric behaviour as a result of the symmetric cavity design and bias conditions. However, the second photon density curve **1808** indicates a reduced photon density distribution in the central section **310.** This happens because of only low biasing of the central section **310,** because the central section **310** serves as passive reflector only. The low biasing is performed to avoid crosstalk between uncorrelated photons from the central section **310** and the two optical modulation signals from the two outer gain sections **308A** and **308B,** while excess absorption loss in the central section **310** is reduced. The absence of DFB type gratings in outer gain sections, such the first outer gain section **208A** and the second outer gain section **208B,** of the laser device **200** (of FIG. 2), in the Fabry-Perot-type gain sections, such as the first outer gain section **308A** and the second outer gain section **308B,** of the laser device **300** (of FIG. 3), becomes obvious though from the different amplification behaviour of the forward and reverse travelling photon density with the respective outer gain sections of the two laser devices.

FIG. 18B is a graphical representation that depicts distribution of a photon density in each section of a laser device on a logarithmic scale, in accordance with yet another embodiment of the present disclosure. FIG. 18B is described in conjunction with elements from FIG. 3 and FIG. 18A. With reference to FIG. 18B, there is shown a graphical representation **1800B** that depicts distribution of a photon density on a logarithmic scale in the first outer gain section **308A,** the second outer gain section **308B,** and the central section **310** of the laser device **300** (of FIG. 3).

The graphical representation **1800B** represents longitudinal position of each of the first outer gain section **308A,** the second outer gain section **308B,** and the central section **310** in µm on an X-axis **1812** and values of photon density in cm⁻³ on a Y-axis **1814.** A first photon density curve **1816** represents the photon density in the first outer gain section **308A** on a logarithmic scale. A second photon density curve **1818** represents the photon density in the central section **310** on the logarithmic scale. A third photon density curve **1820** represents the photon density in the second outer gain section **308B** on the logarithmic scale. From the first photon density curve **1816** and the third photon density curve **1820,** it can be observed that the photon density distribution experiences amplification in the two outer gain sections, such as the first outer gain section **308A** and the second outer gain section **308B.** Moreover, the first photon density curve **1816** and the third photon density curve **1820** show a symmetric behaviour as a result of the symmetric cavity design and bias conditions. However, the second photon density curve **1818** indicates a reduced photon density distribution (e.g., a reduction of two orders of magnitude) in the central section **310.** This happens because of only low biasing of the central section **310,** because the central section **310** serves as passive reflector only. The low biasing is performed to avoid crosstalk between uncorrelated photons from the central section **310** and the two optical modulation signals from the outer gain sections **308A and 308B,** while excess absorption loss in the central section **310** is reduced. The absence of DFB type gratings in outer gain sections, such the first outer gain section **208A** and the second outer gain section **208B,** of the laser device **200** (of FIG. 2), in the Fabry-Perot-type gain sections, such as the first outer gain section **308A** and the second outer gain section **308B,** of the laser device **300** (of FIG. 3), becomes obvious though from the different amplification behaviour of the forward and reverse travelling photon density with the respective outer gain sections of the two laser devices.

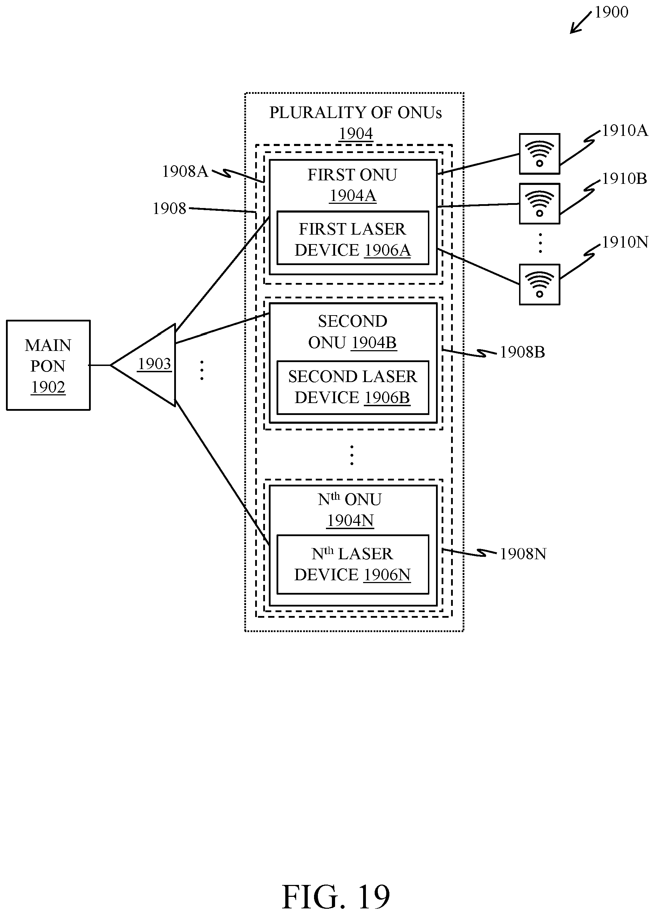

FIG. 19 is an implementation scenario of a passive optical network, in accordance with an embodiment of the present disclosure. FIG. 19 is described in conjunction with elements from FIG. 1. FIG. 2, FIG. 3, FIG. 4, FIG. 5 and FIG. 6. With reference to FIG. 19, there is shown a passive optical network **1900** that includes a main-PON optical line termination (OLT) **1902,** a passive optical connector 1903, and a plurality of optical network units (ONUs) **1904.** The plurality of ONUs **1904** includes a first ONU **1904A,** a second ONU **1904B** upto a Nth ONU **1904N.** Each of the plurality of ONUs **1904** includes a respective laser device, such as the first ONU **1904A** includes a first laser device **1906A,** the second ONU **1904B** includes a second laser device **1906B** and the Nth ONU **1904N** includes a Nth laser device **1906N.** There is further shown a plurality of sub-PONs **1908** that includes a first sub-PON **1908A,** a second sub-PON **1908B** up to a Nth sub-PON **1908N.** Each of the plurality of ONUs **1904** is connected to one or more users, such as the first ONU **1904A** is connected to N number of users, namely, **1910A, 1910B,** ..., **1910N.**

The passive optical network **1900** may refer to a point-to-multipoint optical network architecture that uses passive optical components to provide increased data rates and to divide an optical fiber bandwidth among one or more users, such as the N number of users, **1910A, 1910B,** ..., **1910N.** The passive optical network **1900** provides high speed bandwidth, high flexibility, high reliability, high adaptability, easy management, and low cost per end-user. Examples of the passive optical network **1900** include, but are not limited to, fiber to the home (FTTH), fiber to the curb (FTTC), fiber to the building (FTTB), fiber to the floor (FTTF), fiber to the room (FTTR), and the like.

The passive optical network **1900** comprises a main-PON which is accessed through the OLT **1902.** The main-PON may refer to a PON at a broader geographical area, such as fiber to the building (FTTB). The main-PON is configured to transmit and receive data to and from the plurality of ONUs **1904** via the main-PON OLT 1902. The data from the main-PON received through the OLT **1902** is transmitted through an optical fiber to the plurality of ONUs **1904,** with the help of the passive optical connector **1903.** The passive optical connector **1903** may be configured to function as a passive optical splitter. The passive optical connector **1903** is configured to split the data received from the main-PON which is further transmitted to the plurality of the ONUs **1904** in a downstream channel. Similarly, the data from the plurality of the ONUs **1904** can be transmitted to the main-PON via the main-PON OLT **1902,** by use of the passive optical connector **1903** in an upstream channel. In the upstream channel, the passive optical connector **1903** is configured to function as a passive optical combiner in order to combine the data received from the plurality of ONUs **1904** which is further transmitted to the main-PON via the main-PON OLT **1902** after combination.

The passive optical network **1900** further comprises the plurality of sub-PONs **1908** including the first sub-PON **1908A,** the second sub-PON **1908B** upto the Nth sub-PON **1908N.** Each of the plurality of sub-PONs **1908** may be referred to as a PON of smaller geographical area, such as fiber to the room (FTTR). Since there can be multiple rooms in a building, the plurality of sub-PONs **1908** may exist simultaneously. Each of the plurality of sub-PONs **1908** can include one or more ONUs. Moreover, each of the plurality of sub-PONs **1908** may be configured to receive and transmit data from and to the plurality of ONUs **1904,** by use of the respective laser device.

Each of the plurality of ONUs **1904** is configured to receive data from the downstream main-PON via the main-PON OLT **1902.** The optical fiber signal transmitted from the main-PON (e.g., fiber to the building (FTTB)) is received by the plurality of ONUs **1904** which comprise the plurality of sub-PONs **1908** (e.g., fiber to the room (FTTR)). Each of the plurality of ONUs **1904** may be referred to as a user side equipment, which converts the optical fiber signal into an electrical signal at the user side and enables reliable optical fiber ethernet services to one or more businesses or residential users, such as the N number of users **1910A, 1910B,** ..., **1910N.** Examples of the N number of users **1910A, 1910B,** ..., **1910N** include, but are not limited to a smart phone, a laptop computer, an Internet-of-Things (IoT) device, a machine type communication (MTC) device, an evolved universal mobile telecommunications system (UMTS) terrestrial radio access (E-UTRAN), NR-dual connectivity (EN-DC) device, a drone, a customized hardware for wireless telecommunication, or any other portable or non-portable electronic device.

Additionally, the first ONU **1904A** includes the first laser device **1906A,** the second ONU **1904B** includes the second laser device **1906B** and the Nth ONU **1904N** includes the Nth laser device **1906N.** Each of the first laser device **1906A,** the second laser device **1906B** upto the Nth laser device **1906N** corresponds to one of the laser devices **100, 200, 300, 400, 500** and **600** (of FIGs. 1 to 6). Therefore, the first laser cavity (e.g., as formed between the central section **110** and the the first output laser facet **112A** of the laser device **100)** of each of the laser devices (i.e., **1906A, 1906B,** ... **1906N**), is configured to transmit the first directly modulated optical output signal (e.g., the first directly modulated optical output signal **118A)** to the upstream main-PON and the second laser cavity (e.g., as formed between the central section **110** and the second output laser facet **112B** of the laser device **100)** of each of the laser devices (i.e., **1906A, 1906B, ...1906N),** is configured to transmit the second directly modulated optical output signal (e.g., the second directly modulated optical output signal **118B)** to the downstream sub-PON that is the plurality of sub-PON **1908.** Hence, an optical link is established between the main-PON (i.e., fiber to the building (FTTB)), and the plurality of sub-PONs **1908** (i.e., fiber to the room (FTTR)), with the help of each of the laser devices **(1906A, 1906B, ...,1906N),** of the respective ONU. By virtue of the optical link between the main-PON **1902** and the plurality of sub-PONs **1908,** an overall implementation cost of the passive optical network **1900** is reduced as compared to the cost of the individual conventional main-PON and/or sub-PON, because each of laser devices **(1906A, 1906B, ...,1906N),** provides enhanced functionality in a way that it has both upstream main PON and downstream sub-PON capabilities. By virtue of using the laser devices **(1906A, 1906B, ..., 1906N**), the power consumption of the PON **1900** is significantly reduced which further results into more energy efficiency.

The scope of the invention is defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. The word "exemplary" is used herein to mean "serving as an example, instance or illustration". Any embodiment described as "exemplary" is not necessarily to be construed as preferred or advantageous over other embodiments and/or to exclude the incorporation of features from other embodiments. The word "optionally" is used herein to mean "is provided in some embodiments and not provided in other embodiments". It is appreciated that certain features of the present disclosure, which are, for clarity, described in the context of separate embodiments, may also be provided in combination in a single embodiment. Conversely, various features of the present disclosure, which are, for brevity, described in the context of a single embodiment, may also be provided separately or in any suitable combination or as suitable in any other described embodiment of the disclosure.

## Claims

1. A dual output directly modulated laser device (100, 200, 300, 400, 500, 600) for generating two distinct optical output signals, comprising:
two outer gain sections, each directly modulated by injection of a respective modulation current; and
a central section (110, 210, 310, 410, 510, 610) comprising a distributed reflector;
a first output laser facet (112A, 212A, 312A, 412A, 512A, 612A) and a second output laser facet (112B, 212B, 312B, 412B, 512B, 612B);
**characterized in that**
the distributed reflector is configured to provide optical feedback to both outer gain sections while preventing the generation of stimulated photons; and **in that**
the two outer gain sections form two laser cavities each configured to emit a directly modulated signal as an optical output signal in a direction away from the central section (110, 210, 310, 410, 510, 610);
wherein a first laser cavity of the two laser cavities is formed between the central section and the first output laser facet;
wherein a second laser cavity of the two laser cavities is formed between the central section and the second output laser facet.

2. The laser device (100, 200, 300, 400, 500, 600) of claim 1, wherein a length of the central section (110, 210, 310, 410, 510, 610) is selected such that transmission between the outer gain sections is less than a predefined level.

3. The laser device (100, 200, 300, 400, 500, 600) of claim 1 or claim 2, wherein a length of a first outer gain section (108A, 208A, 308A, 408A, 508A, 608A) is longer than a length of a second outer gain section (108B, 208B, 308B, 408B, 508B, 608B), such that a power output of a corresponding first laser output facet (112A, 312A, 412A, 512A, 612A) is greater than a power output of a second laser output facet (112B, 312B, 412B, 512B, 612B).

4. The laser device (100, 200, 300, 400, 500, 600) of any preceding claim, wherein a data rate of a first modulation current is different to a data rate of a second modulation current.

5. The laser device (100, 200, 300, 400, 500, 600) of any preceding claim, wherein the central section (110, 210, 310, 410, 510, 610) comprises an active region material layer (106, 206, 306, 406) biased such that an optical gain of the central section (110, 210, 310, 410, 510, 610) is substantially the same or less than an aggregated optical loss associated with the central section (110, 210, 310, 410, 510, 610).

6. The laser device (100, 200, 300, 400, 500, 600) of claim 5, wherein the two outer gain sections share a common active region material layer (106, 206, 306, 406) with the central section (110, 210, 310, 410, 510, 610).

7. The laser device (100, 200, 300, 400, 500, 600) of claim 5, wherein an active region material layer (106, 206, 306, 406) of the laser device (100, 200, 300, 400, 500, 600) is formed of two halves, each half configured to emit a different wavelength band.

8. The laser device (100, 200, 300, 400, 500, 600) of any one of claims 1 to 4, where the central section (110, 210, 310, 410, 510, 610) comprises a waveguide (606B) formed from a passive material.

9. The laser device (100, 200, 300, 400, 500, 600) of any preceding claim, wherein the reflector is a high-refractive index distributed Bragg reflector.

10. The laser device (100, 200, 300, 400, 500, 600) of any preceding claim, wherein the laser device (100, 200, 300, 400, 500, 600) is divided into three independent sections by etching isolation trenches between adjacent electrical contacts for each of the section.

11. The laser device (100, 200, 300, 400, 500, 600) of any preceding claim, wherein each of the cavities is configured as a Fabry-Perot-type cavity.

12. The laser device (100, 200, 300, 400, 500, 600) of any one of claims 1 to 10, wherein each of the cavities comprises a grating to select a predefined wavelength for the cavity.

13. The laser device (100, 200, 300, 400, 500, 600) of claim 12, wherein a different wavelength is selected for each cavity.

14. An optical network unit, ONU, configured to receive data from a downstream main passive optical network , PON, and comprising the laser device (100, 200, 300, 400, 500, 600) of any preceding claim,
wherein a first outer gain section (108A, 208A, 308A, 408A, 508A, 608A) of the laser device (100, 200, 300, 400, 500, 600) is configured to transmit a first directly modulated optical output signal (118A, 218A, 318A, 418A, 518A, 618A) to the upstream main-PON, and
wherein a second outer gain section (108B, 208B, 308B, 408B, 508B, 608B) of the laser device (100, 200, 300, 400, 500, 600) is configured to transmit a second directly modulated optical output signal (118B, 218B, 318B, 418B, 518B, 618B) to a downstream sub-PON.

15. A passive optical network (1900), PON, comprising:
a main-PON configured to transmit and receive data to and from a plurality of ONUs (1904) of claim 14, and
a plurality of sub-PONs (1908) corresponding receive and transmit data from and to the plurality of ONUs (1904).

## Patentansprüche

1. Direkt modulierte Laservorrichtung (100, 200, 300, 400, 500, 600) mit zwei Ausgängen zum Erzeugen zweier unterschiedlicher optischer Ausgangssignale, umfassend:
zwei äußere Verstärkungsabschnitte, die jeweils direkt durch Injektion eines entsprechenden Modulationsstroms moduliert werden; und
einen mittleren Abschnitt (110, 210, 310, 410, 510, 610), der einen verteilten Reflektor umfasst;
eine erste Ausgangslaserfacette (112A, 212A, 312A, 412A, 512A, 612A) und eine zweite Ausgangslaserfacette (112B, 212B, 312B, 412B, 512B, 612B);
**dadurch gekennzeichnet, dass**
der verteilte Reflektor konfiguriert ist, um optische Rückkopplung an beide äußeren Verstärkungsabschnitte bereitzustellen und gleichzeitig die Erzeugung stimulierter Photonen zu verhindern; und dadurch, dass
die beiden äußeren Verstärkungsabschnitte zwei Laserkavitäten bilden, die jeweils konfiguriert sind, um ein direkt moduliertes Signal als optisches Ausgangssignal in eine Richtung weg von dem mittleren Abschnitt (110, 210, 310, 410, 510, 610) zu emittieren; wobei eine erste Laserkavität der zwei Laserkavitäten zwischen dem mittleren Abschnitt und der ersten Ausgangslaserfacette gebildet ist;
wobei eine zweite Laserkavität der zwei Laserkavitäten zwischen dem mittleren Abschnitt und der zweiten Ausgangslaserfacette gebildet ist.

2. Laservorrichtung (100, 200, 300, 400, 500, 600) nach Anspruch 1, wobei eine Länge des mittleren Abschnitts (110, 210, 310, 410, 510, 610) derart ausgewählt ist, dass eine Transmission zwischen den äußeren Verstärkungsabschnitten geringer als ein vordefinierter Pegel ist.

3. Laservorrichtung (100, 200, 300, 400, 500, 600) nach Anspruch 1 oder Anspruch 2, wobei eine Länge eines ersten äußeren Verstärkungsabschnitts (108A, 208A, 308A, 408A, 508A, 608A) derart länger ist als eine Länge eines zweiten äußeren Verstärkungsabschnitts (108B, 208B, 308B, 408B, 508B, 608B), dass eine Leistungsabgabe einer entsprechenden ersten Laserausgangsfacette (112A, 312A, 412A, 512A, 612A) größer ist als eine Leistungsabgabe einer zweiten Laserausgangsfacette (112B, 312B, 412B, 512B, 612B).

4. Laservorrichtung (100, 200, 300, 400, 500, 600) nach einem der vorhergehenden Ansprüche, wobei sich eine Datenrate eines ersten Modulationsstroms von einer Datenrate eines zweiten Modulationsstroms unterscheidet.

5. Laservorrichtung (100, 200, 300, 400, 500, 600) nach einem der vorhergehenden Ansprüche, wobei der mittlere Abschnitt (110, 210, 310, 410, 510, 610) eine Materialschicht (106, 206, 306, 406) eines aktiven Bereichs umfasst, die derart vorgespannt ist, dass eine optische Verstärkung des mittleren Abschnitts (110, 210, 310, 410, 510, 610) im Wesentlichen gleich oder kleiner als ein aggregierter optischer Verlust ist, der dem mittleren Abschnitt (110, 210, 310, 410, 510, 610) zugeordnet ist.

6. Laservorrichtung (100, 200, 300, 400, 500, 600) nach Anspruch 5, wobei die zwei äußeren Verstärkungsabschnitte eine gemeinsame Materialschicht (106, 206, 306, 406) des aktiven Bereichs mit dem mittleren Abschnitt (110, 210, 310, 410, 510, 610) teilen.

7. Laservorrichtung (100, 200, 300, 400, 500, 600) nach Anspruch 5, wobei eine Materialschicht (106, 206, 306, 406) des aktiven Bereichs der Laservorrichtung (100, 200, 300, 400, 500, 600) aus zwei Hälften gebildet ist, von denen jede Hälfte konfiguriert ist, um ein anderes Wellenlängenband zu emittieren.

8. Laservorrichtung (100, 200, 300, 400, 500, 600) nach einem der Ansprüche 1 bis 4, wobei der zentrale Abschnitt (110, 210, 310, 410, 510, 610) einen Wellenleiter (606B) umfasst, der aus einem passiven Material gebildet ist.

9. Laservorrichtung (100, 200, 300, 400, 500, 600) nach einem der vorhergehenden Ansprüche, wobei der Reflektor ein verteilter Bragg-Reflektor mit hohem Brechungsindex ist.

10. Laservorrichtung (100, 200, 300, 400, 500, 600) nach einem der vorhergehenden Ansprüche, wobei die Laservorrichtung (100, 200, 300, 400, 500, 600) durch Ätzen von Isolationsgräben zwischen benachbarten elektrischen Kontakten für jeden der Abschnitte in drei unabhängige Abschnitte unterteilt ist.

11. Laservorrichtung (100, 200, 300, 400, 500, 600) nach einem der vorhergehenden Ansprüche, wobei jede der Kavitäten als eine Kavität vom Fabry-Perot-Typ konfiguriert ist.

12. Laservorrichtung (100, 200, 300, 400, 500, 600) nach einem der Ansprüche 1 bis 10, wobei jede der Kavitäten ein Gitter umfasst, um eine vordefinierte Wellenlänge für die Kavität auszuwählen.

13. Laservorrichtung (100, 200, 300, 400, 500, 600) nach Anspruch 12, wobei für jede Kavität eine unterschiedliche Wellenlänge ausgewählt ist.

14. Optische Netzwerkeinheit, ONU, die konfiguriert ist, um Daten von einem nachgeschalteten passiven optischen Hauptnetzwerk, PON, zu empfangen, und die die Laservorrichtung (100, 200, 300, 400, 500, 600) nach einem der vorhergehenden Ansprüche umfasst,
wobei ein erster äußerer Verstärkungsabschnitt (108A, 208A, 308A, 408A, 508A, 608A) der Laservorrichtung (100, 200, 300, 400, 500, 600) konfiguriert ist, um ein erstes direkt moduliertes optisches Ausgangssignal (118A, 218A, 318A, 418A, 518A, 618A) an das vorgeschaltete Haupt-PON zu übertragen, und
wobei ein zweiter äußerer Verstärkungsabschnitt (108B, 208B, 308B, 408B, 508B, 608B) der Laservorrichtung (100, 200, 300, 400, 500, 600) konfiguriert ist, um ein zweites direkt moduliertes optisches Ausgangssignal (118B, 218B, 318B, 418B, 518B, 618B) an ein nachgeschaltetes Sub-PON zu übertragen.

15. Passives optisches Netzwerk (1900), PON, umfassend:
ein Haupt-PON, das konfiguriert ist, um Daten an eine Vielzahl von ONUs (1904) nach Anspruch 14 zu übertragen und davon zu empfangen, und
eine entsprechende Vielzahl von Sub-PONs (1908), die Daten von der Vielzahl von ONUs (1904) empfängt und dahin überträgt.

## Revendications

1. Dispositif laser à modulation directe à double sortie (100, 200, 300, 400, 500, 600) pour générer deux signaux de sortie optiques distincts, comprenant :
deux sections de gain externes, chacune directement modulée par injection d'un courant de modulation respectif ; et
une section centrale (110, 210, 310, 410, 510, 610) comprenant un réflecteur distribué ;
une première facette laser de sortie (112A, 212A, 312A, 412A, 512A, 612A) et une seconde facette laser de sortie (112B, 212B, 312B, 412B, 512B, 612B) ;
**caractérisé en ce que**
le réflecteur distribué est configuré pour fournir une rétroaction optique aux deux sections de gain externes tout en empêchant la génération de photons stimulés ; et **en ce que**
les deux sections de gain externes forment deux cavités laser chacune configurée pour émettre un signal directement modulé en tant que signal de sortie optique dans une direction éloignée de la section centrale (110, 210, 310, 410, 510, 610) ;
dans lequel une première cavité laser des deux cavités laser est formée entre la section centrale et la première facette laser de sortie ;
dans lequel une seconde cavité laser des deux cavités laser est formée entre la section centrale et la seconde facette laser de sortie.

2. Dispositif laser (100, 200, 300, 400, 500, 600) selon la revendication 1, dans lequel une longueur de la section centrale (110, 210, 310, 410, 510, 610) est sélectionnée de sorte que la transmission entre les sections de gain externes est inférieure à un niveau prédéfini.

3. Dispositif laser (100, 200, 300, 400, 500, 600) selon la revendication 1 ou la revendication 2, dans lequel une longueur d'une première section de gain externe (108A, 208A, 308A, 408A, 508A, 608A) est plus longue qu'une longueur d'une seconde section de gain externe (108B, 208B, 308B, 408B, 508B, 608B), de sorte qu'une puissance de sortie d'une première facette de sortie laser (112A, 312A, 412A, 512A, 612A) correspondante est supérieure à une puissance de sortie d'une seconde facette de sortie laser (112B, 312B, 412B, 512B, 612B).

4. Dispositif laser (100, 200, 300, 400, 500, 600) selon une quelconque revendication précédente, dans lequel un débit de données d'un premier courant de modulation est différent d'un débit de données d'un second courant de modulation.

5. Dispositif laser (100, 200, 300, 400, 500, 600) selon une quelconque revendication précédente, dans lequel la section centrale (110, 210, 310, 410, 510, 610) comprend une couche de matériau de région active (106, 206, 306, 406) polarisée de sorte qu'un gain optique de la section centrale (110, 210, 310, 410, 510, 610) est sensiblement égal ou inférieur à une perte optique agrégée associée à la section centrale (110, 210, 310, 410, 510, 610).

6. Dispositif laser (100, 200, 300, 400, 500, 600) selon la revendication 5, dans lequel les deux sections de gain externes partagent une couche de matériau de région active commune (106, 206, 306, 406) avec la section centrale (110, 210, 310, 410, 510, 610).

7. Dispositif laser (100, 200, 300, 400, 500, 600) selon la revendication 5, dans lequel une couche de matériau de région active (106, 206, 306, 406) du dispositif laser (100, 200, 300, 400, 500, 600) est formée de deux moitiés, chaque moitié étant configurée pour émettre une bande de longueur d'onde différente.

8. Dispositif laser (100, 200, 300, 400, 500, 600) selon l'une quelconque des revendications 1 à 4, dans lequel la section centrale (110, 210, 310, 410, 510, 610) comprend un guide d'ondes (606B) formé à partir d'un matériau passif.

9. Dispositif laser (100, 200, 300, 400, 500, 600) selon une quelconque revendication précédente, dans lequel le réflecteur est un réflecteur de Bragg distribué à indice de réfraction élevé.

10. Dispositif laser (100, 200, 300, 400, 500, 600) selon une quelconque revendication précédente, dans lequel le dispositif laser (100, 200, 300, 400, 500, 600) est divisé en trois sections indépendantes par gravure de tranchées d'isolation entre des contacts électriques adjacents pour chacune des sections.

11. Dispositif laser (100, 200, 300, 400, 500, 600) selon une quelconque revendication précédente, dans lequel chacune des cavités est configurée comme une cavité de type Fabry-Perot.

12. Dispositif laser (100, 200, 300, 400, 500, 600) selon l'une quelconque des revendications 1 à 10, dans lequel chacune des cavités comprend un réseau pour sélectionner une longueur d'onde prédéfinie pour la cavité.

13. Dispositif laser (100, 200, 300, 400, 500, 600) selon la revendication 12, dans lequel une longueur d'onde différente est sélectionnée pour chaque cavité.

14. Unité de réseau optique, ONU, configurée pour recevoir des données d'un réseau optique passif, PON, principal en aval et comprenant le dispositif laser (100, 200, 300, 400, 500, 600) selon une quelconque revendication précédente,
dans lequel une première section de gain externe (108A, 208A, 308A, 408A, 508A, 608A) du dispositif laser (100, 200, 300, 400, 500, 600) est configurée pour transmettre un premier signal de sortie optique modulé directement (118A, 218A, 318A, 418A, 518A, 618A) au PON principal en amont, et
dans lequel une seconde section de gain externe (108B, 208B, 308B, 408B, 508B, 608B) du dispositif laser (100, 200, 300, 400, 500, 600) est configurée pour transmettre un second signal de sortie optique modulé directement (118B, 218B, 318B, 418B, 518B, 618B) à un sous-PON en aval.

15. Réseau optique passif (1900), PON, comprenant :
un PON principal configuré pour transmettre et recevoir des données vers et depuis une pluralité d'ONU (1904) selon la revendication 14, et
une pluralité de sous-PON (1908) correspondant reçoivent et transmettent des données depuis et vers la pluralité d'ONU (1904) .
